## Europäisches Patentamt
## European Patent Office
## Office européen des brevets

(19)

(11) Veröffentlichungsnummer: **0 065 037**
**B1**

(12)

# EUROPÄISCHE PATENTSCHRIFT

(45) Veröffentlichungstag der Patentschrift:
03.02.88

(21) Anmeldenummer: 81108598.4

(22) Anmeldetag: 20.10.81

(51) Int. Cl.⁴: **G 06 F 3/00**, H 03 K 19/173

(54) Schaltungsanordnung für eine aus gleichartigen Halbleiterbausteinen aufgebaute logische Verknüpfungsanordnung.

(30) Priorität: 27.04.81 DE 3116659

(43) Veröffentlichungstag der Anmeldung:
24.11.82 Patentblatt 82/47

(45) Bekanntmachung des Hinweises auf die Patenterteilung:
03.02.88 Patentblatt 88/5

(84) Benannte Vertragsstaaten:
AT BE CH FR GB IT LI NL SE

(56) Entgegenhaltungen:
GB-A-1 065 585
GB-A-1 102 465
GB-A-2 014 771
US-A-3 699 538
US-A-3 988 717

COMPUTER DESIGN, Band 10, Nr. 12, Dezember 1971, Seiten 35-40, Concord, Mass., US; A.D.GOLDSTEIN: "Advanced packaging and MOS/LSI used in miniature computer design"

(73) Patentinhaber: Siemens Aktiengesellschaft Berlin und München, Wittelsbacherplatz 2, D-8000 München 2 (DE)

(72) Erfinder: Katsaros, Damianos, Dipl.- Ing., Untere Parkstrasse 19, D-8013 Haar (DE)

EP 0 065 037 B1

## Beschreibung

Die Erfindung betrifft eine logische Verknüpfungsschaltung, bestehend aus mehreren gleichartigen Halbleiterbausteinen in hhochintegrierter Schaltkreistechnik.

Im Zuge der Weiterentwicklung der Halbleitertechnik hat sich der Komplexitätsgrad von digitalen hochintegrierten Schaltungen (LSI) wesentlich erhöht. Dies hat zu einer erheblichen Verbilligung der Herstellung von elektronischen Rechnern oder sonstigen Datenverarbeitungssystemen geführt. Erstens haben sich die unmittelbaren Kosten der LSI-Schaltungen vermindert. Zweitens hat der wesentlich erhöhte funktionelle Komplexitätsgrad der LSI-Schaltungen zu einer starken Verminderung der Anzahl integrierter Schaltungsbausteine geführt, welche zur Bildung bestimmten Systems miteinander verbunden werden müssen. Daduch ist die Zuverlässigkeit des Systems erhöht worden und die Kosten der gedruckten Schaltungsplatten, auf welchen die integrierten Schaltungsbausteine montiert sind, sind vermindert worden.

Obwohl bestimmte Teile eines typischen elektronischen Rechners oder Computers, wie beispielsweise der Hauptspeicher, die arithmetische/logische Einheit und der Firmware-Speicher, durch Verwendung kommerziell erhältlicher standardisierter LSI-Schaltungen realisiert werden können, wie beispielsweise durch Speicherschaltungen mit wahlweisem Zugriff (RAM), Festwertspeicher (ROM) und arithmetische Schaltungen (ALU), können andere Teile des Rechners, die im folgenden als wahlfreie Logikteile bezeichnet werden, nicht ohne weiteres mit solchen standardisierten Bausteinen realisiert werden. Diese wahlfreien Logikteile enthalten verschiedene Verbindungen oder Verschaltungen von logischen Schaltungen bzw. Verknüpfungsnetzwerken, die für eine bestimmte Ausführungsform des Rechners charakteristisch sind. Bei der Entwicklung eines Rechners bereitet es daher Schwierigkeiten, für diese wahlfreien Logikteile die Vorteile von · standardisierten LSI-Schaltungen, die in großen Stückzahlen gefertigt werden und demzufolge niedrige Kosten je Funktion ergeben, voll zu nutzen, weil viele unterschiedliche Verknüpfungsfunktionen realisiert werden müssen, um die vielen unterschiedlichen Eingangsvariablen zu vielen unterschiedlichen Ausgangsgrößen zu verknüpfen.

Das Bedürfnis, die Anzahl der benötigten verschiedenen Arten von LSI-Schaltungen für wahlfreie Logikteile zu verringern hat bereits zu verschiedenen Lösungen geführt, um durch eine größere Stückzahl je Baustein die Kosten zu senken.

So ist durch die GB-A-20 14 771 eine in einem integrierten Halbleiterbaustein zusammengefaßte Decodierschaltung bekannt, die aus mehreren Grunddecodierern besteht, denen eine Reihe von Auswählschaltern vorgeschaltet ist. Über diese Auswählschalter werden an Eingangsklemmen anliegende zu decodierende binäre Adressensignale abhängig von zwei Betriebsartenwählsignalen so auf die Grunddecodierer verteilt, daß die Decodierschaltung abhängig von den Betriebsartenwählsignalen folgende vier Verwendungsmöglichkeiten zuläßt:

1. Als drei voneinander unabhängig arbeitende "3 zu 8"-Decodie-rer,

2. als zwei unabhängig voneinander arbeitende "4 zu 16"- und "3 zu 8"-Decodierer,

3. als ein einziger "5 zu 24"-Decodierer für die ersten Kombinationen 1 bis 24 und

4. als ein einziger "5 zu 24"-Decodierer für die letzten Kombinationen 9 bis 32.

Aus zwei solchen Decodierbausteinen kann dann bei entspechender Beschaltung der Eingangsklemmen und entsprechender Wahl der Betriebsartenwählsignale ein "5 zu 32"-Decodierer und aus vier solcher Bausteine ein "6 zu 64"-Decodierer gebildet werden, d.h. eine aus gleichartigen Halbleiterbausteinen ausgebaute logische Verknüpfungsanordnung geschaffen werden. Die durch die Auswähleinrichtung bedingte Umschaltung der Eingangsvariablen auf verschiedene Eingänge der vorhandenen Grunddecodierer ermöglicht in diesem Falle eine interne Umstrukturierung der Bausteine entsprechend den vielfältigen Anforderungen bezüglich des unterschiedlichen Umfangs der zu decodierenden binären Adressen.

Eine andere, durch die US-A-39 88 717 bekannte Lösung betrifft eine Mehrzweckbaustein für Rechner, der sowohl für die arithmetische Einheit als auch für die Mikrobefehlssteuerung verwendet werden kann. Dieser aus Registern, Speichern, einer arithmetisch/logischen Einheit und Multiplexern bestehende Baustein verarbeitet jeweils abhängig von einem zugeführten Operationscode zwei, jeweils 4 Bit umfassende Operanden in der durch den Operationscode vorgegebenen Weise zu einem 4 Bit umfassenden Ergebnis. Sind Operanden von 8 oder 16 Bit zu verarbeiten, dann werden entsprechend 2 oder 4 solcher Bausteine parallelgeschaltet und diesen jeweils derselbe Operationscode zugeführt. Es wird also ebenfalls eine aus mehreren gleichartigen Halbleiterbausteinen bestehende logische Verknüpfungsanordnung gebildet. Jedoch erfolgt in diesem Falle die Erweiterung entsprechend der bekannten Scheibchen oder "Slice"-Technik, nach der gleichartige, jeweils ein Bit oder mehrere Bits gleichzeitig in gleicher Weise verarbeitende Bausteine als Module parallel arbeitend zu einer Gesamtanordnung zusammengefaßt werden wobei durch für alle Bausteine einheitliche Steuersignale die jeweils auszuführende Funktion der Module festgelegt wird.

Die bei diesen beiden bekannten Lösungen zugrundeliegenden Strukturen der Halbleiterbausteine erlauben zwar für bestimmte Anwendungsfälle die Realisierung von logischen Verknüpfungsschaltungen mit mehreren gleichartigen Bausteinen in integrierter Schaltkreistechnik, so daß die Stückzahl der benötigten Bausteine gesteigert werden kann. Jedoch sind diese Lösungen nur auf gewisse Anwendungsfälle beschränkt.

Aufgabe der Erfindung ist es daher, durch einen prinzipiell anders gearteten Aufbau der eine logische Verknüpfungsschaltung bildenden Halbleiterbausteine die Realisierung von anderen erforderlichen wahlfreien Logikteilen bei wirtschaftlicher Stückzahl an Bausteinen zu erleichtern.

Diese Aufgabe wird durch die kennzeichnenden Merkmale des Patentanspruches 1 gelöst.

Danach werden die auszuführenden Verknüpfungsfunktionen in zwei Arten aufgeteilt, nämlich in gleichartige Verknüpfungsfunktionen, die mehrmals parallel mit gleichen Logikschaltungen auszuführen sind und jeweils Gruppen gleichartiger Ausgangssignale liefern, und in ungleichartige Verknüpfungsfunktionen, die jeweils individuelle Logikschaltungen zur Erzeugung eines Ausgangssignales erfordern. Dabei werden in Anlehnung an die bekannte "Slice"-Technik die Logikschaltungen für die Durchführung gleichartiger Verknüpfungsfunktionen gleichmäßig auf alle Halbleiterbausteine der Verknüpfungsanordnung verteilt, während die Logikschaltungen für alle ungleichartigen Verknüpfungsfunktionen in gleicher Weise auf jedem Halbleiterbaustein, also entsprechend mehrfach vorgesehen werden. Durch steuerbare Auswahlschalter wird dann das jeweils mehrfach gebildete Verknüpfungsergebnis einer vorgegebenen logischen Verknüpfungsfunktion bei einem der Halbleiterbausteine für die weitere Verarbeitung als Ausgangssignal an einer vorgegebenen Ausgangsklemme freigegeben. Jeder von n Halbleiterbausteinen kann also alle Ausgangssignale inhomogener Struktur bilden, genutzt wird jedoch nur ein vorbestimmter Teil davon, während jeweils nur 1/n der Ausgangssignale homogener Struktur auf jedem Halbleiterbaustein gebildet wird.

Insgesamt ermöglicht die Erfindung die Aufteilung auch komplexer Schaltungsanordnungen mit wahlfreien Logikteilen auf gleichartige Halbleiterbausteine, die daher in größerer Stückzahl mit niedrigeren Kosten hergestellt werden können. Durch die Auswahlschaltglieder für die Ausgangssignale inhomogener Struktur ergibt sich zugleich eine Mehrfachausnutzung der nachgeschalteten Ausgangsklemmen eines jeden Halbleiterbausteines, so daß deren Anzahl auf die Anzahl der tatsächlich zur Auswertung freigegebenen Ausgangssignale und damit für ein Minimum beschränkt bleibt.

Erfolgt zudem die Einstellung der Auswahlschaltglieder durch statische Signale, so sind auch die von jedem Halbleiterbaustein an den einzelnen Ausgangsklemmen gelieferten Ausgangssignale festgelegt.

In analoger Weise läßt sich zusätzlich durch Mehrfachausnutzung eines Teiles der Eingangsklemmen bei jedem Halbleiterbaustein die Anzahl der benötigten Eingangsklemmen verringern, indem die von jedem Halbleiterbaustein gleichermaßen benötigten Eingangsvariablen jeweils parallel allen Halbleiterbausteinen an miteinander korrespondierenden Eingangsklemmen zugeführt werden, während für die übrigen, abhängig von der Einstellung der Auswahlschaltglieder jeweils benötigten Eingangsvariablen auf jedem Halbleiterbaustein eine Gruppe von miteinander korrespondierenden Eingangsklemmen vorgesehen ist, deren Anzahl der maximalen Anzahl der von einem der Halbleiterbausteine zusätzlich benötigten Eingangsvariablen entspricht und die mit den Eingängen aller entsprechenden Logikschaltungen für die Bildung von Ausgangssignalen inhomogener Struktur verbunden sind.

Ein Teil der für die Bildung von Ausgangssignalen inhomogener Struktur benötigten Eingangsvariablen wird also nicht allen Halbleiterbausteinen parallel zugeführt wie etwa die Eingangsvariablen für die Ausgangssignale mit homogener Struktur, sondern nur die aufgrund der Einstellung der Auswahlschaltglieder benötigten Eingangsvariablen. Die Anzahl der Eingangsklemmen hierfür kann also kleiner sein, jedoch bei allen Halbleiterbausteinen gleich groß, wobei die auf den einzelnen Halbleiterbausteinen miteinander korrespondierenden Eingangsklemmen mit unterschiedlichen Eingangsvariablen beaufschlagt sein können.

Eine weitere Reduzierung des Schaltungsaufwandes läßt sich dadurch erreichen, daß übereinstimmende Verknüpfungsteile für mehrere der Logikschaltungen zur Ableitung von Ausgangssignalen inhomogener Struktur in einer einzigen Teil-Logikschaltung zusammengefaßt sind, der die unterschiedlichen Rest-Logikschaltungen nachgeschaltet sind.

Gemäß einer Weiterbildung der Erfindung sind auf jedem Halbleiterbaustein wenigstens für eine Reihe von Eingangsvariablen Zwischenspeicher vorgesehen. Auf diese Weise wird u.a. die Arbeitsweise der Schaltungsanordnung unabhängig von der Verfügungsdauer der Eingangsvariablen.

Eine andere sehr vorteilhafte Weiterbildung der Erfindung besteht darin, daß bei ausreichender Zahl von Ausgängen je Halbleiterbaustein gleichbedeutende Ausgangssignale inhomogener Struktur von zwei Halbleiterbausteinen gleichzeitig abgegeben und einer Signalüberwachung zugeleitet werden. Die Erfindung nutzt damit die zwangsläufig bestehende Redundanz, die sich daraus ergibt, daß die für die Ausgangssignale mit inhomogener Struktur notwendigen Logikschaltungen auf allen Halbleiterbausteinen in gleicher Weise vorgesehen sind, aber nicht in gleichem Umfang benötigt werden.

Weitere Einzelheiten der Erfindung seien nachfolgend anhand eines in der Zeichnung dargestellten Ausführungsbeispieles näher erläutert. Im einzelnen zeigen:

FIG 1 ein schematisches Blockschaltbild eines Halbleiterbausteines gemäß der Erfindung,

FIG 2 ein schematisches Blockschaltbild für die Steuerung einer Prozessoreinheit unter Verwendung einer aus vier gleichen Halbleiterbausteinen gemäß FIG 1 aufgebauten Steuereinrichtung,

FIG 3 eine Tabelle für den Mikrobefehlscode der Prozessoreinheit nach FIG 2 mit Ableitung der Steuerfunktion (ALU-Funktion) für die arithmetische/logische Verknüpfungseinheit (ALU),

FIG 4 eine Tabelle zur Erläuterung der Befehlsgruppen,

FIG 5 u. FIG 6 Tabellen zur Ableitung der ALU-Funktionen,

FIG 7 die Verknüpfungsformeln für die einzelnen ALU-Funktionen,

FIG 8 eine Tabelle zur Ableitung der Verknüpfungsformel für das ALU-Eingangssignal CIN,

FIG 9 eine Tabelle für die Verteilung der ALU-Funktionssignale auf korrespondierende Ausgänge der einzelnen Halbleiterbausteine,

FIG 10 die Verknüpfungsformel für die homogenen NZD-Teilsignale mit Tabelle für die Verteilung auf die einzelnen Halbleiterbausteine,

FIG 11 die Verknüpfungsformeln für die homogenen BYT SEI-Signale mit Tebelle für die Verteilung auf die einzelnen Halbleiterbausteine,

FIG 12 eine Tabelle zur Erläuterung der ALU-Anzeigen abhängig vom Mikrobefehlscode,

FIG 13 ein Blockschaltbild zur Erläuterung der Ableitung von ALU-Anzeigensignalen aus einzelnen Signalen in Verbindung mit der ALU,

FIG 14 eine Tabelle zur Ableitung der Verknüpfungsformel für die CARRY-Anzeige,

FIG 15 eine Tebelle zur Ableitung der Verküpfungsformel für die SIGN/OV-Anzeige,

FIG 16 eine Tabelle zur Ableitung der Verknüpfungsformel für die PCAR-Anzeige,

FIG 17 eine Tabelle zur Ableitung der Verknüpfungsformel für die NZD-Anzeige,

FIG 18 eine Tabelle zur Ableitung der Verknüpfungsformel für die IVD-Anzeige,

FIG 19 eine Tabelle für die Signalbelegung der korrespondierenden Eingangs- und Ausgangsklemmen-Gruppen der einzelnen Halbleiterbausteine in Verbindung mit den inhomogenen ALU-Anzeigensignalen und

FIG 20 eine Übersicht über die gesamte Klemmbelegung für die vier Halbleiterbausteine der Steuereinrichtung nach FIG 2.

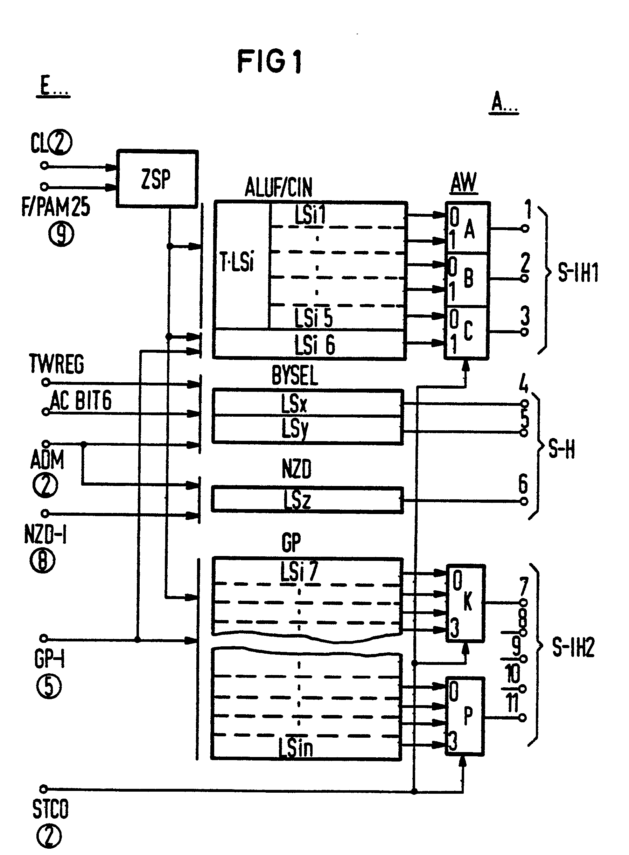

FIG 1 zeigt den strukturellen Aufbau eines Halbleiterbausteines gemäß der Erfindung mit den Eingangsklemmen E... und den Ausgangsklemmen A... Aus den den Eingangsklemmen E... als Eingangsvariable zugeführten Signalen werden die an den Ausgangsklemmen A... abgegebenen Ausgangssignale durch Logikschaltungen LS in an sich bekannter Weise gewonnen. Jede dieser Logikschaltungen LS liefert jeweils ein einziges Ergebnissignal, das im Falle von Ausgangssignalen homogener Struktur unmittelbar an die zugehörige Ausgangsklemme A... geführt ist. Im Gegensatz dazu werden Ausgangssignale inhomogener Struktur jeweils durch Auswahl eines aus einer Gruppe von Ergebnissignalen der Logikschaltungen gebildet. Diese Auswahl übernehmen die Auswahlschaltglieder AW, wobei die Gruppen der Ergebnissignale, unter denen eine Auswahl zu treffen ist, aus jeweils zwei oder jeweils vier Ergebnissignalen beim gewählten Ausführungsbeispiel bestehen können. Die Auswahl unter den einzelnen Ergebnissignalen zur Bildung der Ausgangssignale inhomogener Struktur S-IH erfolgt durch Voreinstellung der einzelnen Auswahlschaltglieder AW anhand der über die Eingangsklemmen STCO zugeführten Einstellsignale. Bei Gruppen von Ergebnissignalen mit maximal vier Ergebnissignalen sind hierfür zwei getrennte Eingangsklemmen STCO erforderlich, was durch eine zusätzlice Ziffer im Kreis angegeben ist. Analoges gilt im übrigen für die übrigen Eingangsklemmen, da für die einzelnen Gruppen von Eingangsvariablen jeweils nur eine Eingangsklemme gezeichnet und durch eine zusätzliche Ziffer im Kreis angegeben ist, wie viele Eingangsklemmen tatsächlich je Gruppe aufzuwenden sind. Beim gewählten Ausführungsbeispiel ergibt das 30 Eingangsklemmen und 11 Ausgangsklemmen.

Die Ausgangssignale gleicher Art bildenden Logikschaltungen LS sind jeweils in Funktionsgruppen zusammengefaßt. Beim vorliegenden Beispiel sind es die Funktionsgruppen ALUF/CIN, BY SEL, NZD und GP. Dabei besteht die Möglichkeit, gemeinsame Verknüpfungsteile mehrerer Logikschaltungen, z. B. der Logikschaltung LSi1 bis LSi5 der Funktionsgruppe ALUF/CIN, in einer gemeinsamen Teil-Logikschaltung TLSi zusammenzufassen und den einzelnen Rest-Logikschaltungen vorzuschalten. Auf diese Weise wird der Schaltungsaufwand insgesamt vermindert, da die gemeinsame Teilverknüpfung von Eingangsvariablen nicht in jeder Logikschaltung gesondert vorgenommen zu werden braucht. Auch können Eingangsvariable in einem Zwischenspeicher ZSP zwischengespeichert werden, falls dieses zweckmäßig ist, etwa um die Arbeitsweise der Schaltungsanordnung unabhängig von der Verfügungsdauer der Eingangsvariablen zu machen. Beim vorliegenden Ausführungsbeispiel trifft dies für die Eingangssignale F/PAM25 zu, die abhängig von Taktsignalen CL nur zu bestimmten Zeiten in den Zwischenspeicher ZSP übernommen werden.

Grundsätzlich ist jede Logikschaltung LS eingangsseitig lediglich mit den Eingangsklemmen E... verbunden, die die entsprechend der der jeweiligen Logikschaltung LS zugrundeliegenden Verknüpfungsformel jeweils benötigten Eingangsvariablen liefert. Dagegen können die auf verschiedenen Halbleiterbausteinen einander entsprechenden Eingangsklemmen E... entweder mit denselben Eingangsvariablen oder wenigstens gleichartigen Eingangsvariablen als auch mit Eingangsvariablen unterschiedlicher Art belegt werden. Letzteres gilt für die Eingangsklemmen GP-I, die abhängig von der Einstellung der Auswahlschaltglieder AW-K bis AW-P von Halbleiterbaustein zu Halbleiterbaustein mit unterschiedlichen Kombinationen von Eingangsvariablen belegt sein können, so daß diese Eingangsklemmen mehrfach ausgenutzt werden.

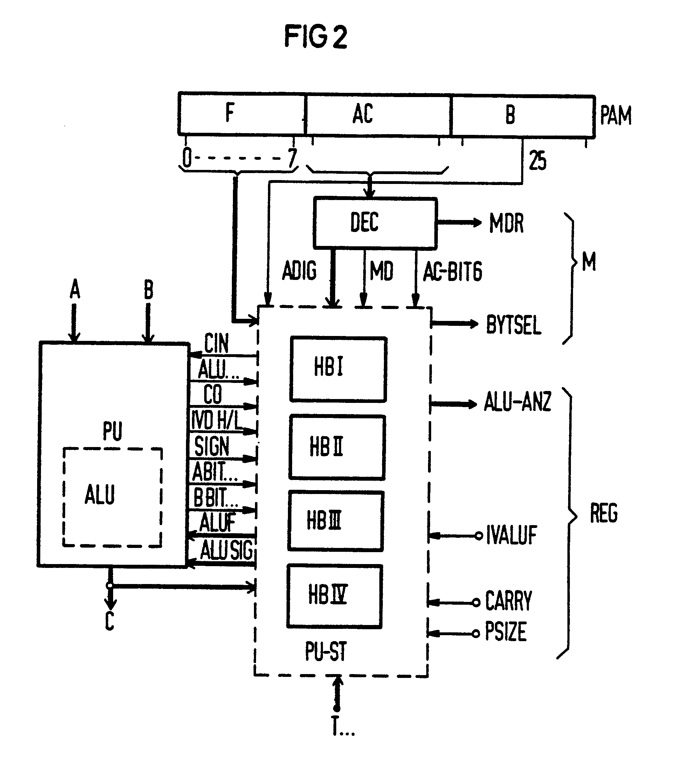

FIG 2 zeigt ein schematisches Blockschaltbild für die Steuerung einer Prozessoreinheit PU unter Verwendung einer aus vier gleichen Halbleiterbausteinen HBI bis HBIV gemäß FIG 1 aufgebauten Steuereinrichtung PU-ST. Wesentlicher Bestandteil der Prozessoreinheit PU ist neben den üblichen Registern und Steuerschaltungen die arithmetische/logische Verknüpfungseinheit ALU, die in an sich bekannter Weise abhängig von zugeführten Steuersignalen ALUF zur Bestimmung der ALU-Funktion und dem Eingangsübertrag CIN die beiden Operanden A und B zum Ergebnis C verknüpft. Andererseits werden von der ALU Steuersignale für die Ableitung der ALU-Anzeigen ALU-ANZ an die Steuereinrichtung PU-ST geliefert. Weitere Steuersignale erhält die Steuereinrichtung PU-ST aus dem zuständigen Mikrobefehlsregister PAM, das beispielsweise 32 Bit breit ist. Dieses Register zerfällt normalerweise in drei Teile, nämlich den Teil F, der den eigentlichen Mikrobefehlscode enthält, und die beiden Teie AC und B, die neben Steuerinformationen die Adressen für die beiden zu verknüpfenden Operanden liefern. Die Auswertung der Informationen in den beiden Teilen AC und B des Mikrobefehlsregisters erfolgt bekanntlich durch Decoder DEC, von denen im vorliegenden Falle nur der für den Teilbereich AC dargestellt ist. Dieser Decoder liefert mit den Signalen ADIG Aussagen über die gültigen Digits im Operanden A sowie Steuer- und Adressensignale bei einer Ansteuerung des Speichers M. Darüber hinaus sind noch die drei Signale IVALUF, CARRY und PSIZE angedeutet, die in an sich bekannter Weise von Steuerregistern REG geliefert werden und deren Bedeutung im nachfolgenden noch näher erläutert wird. Alle der Steuereinrichtung PU-ST zugeführten Signale werden von den vier gleichartig ausgebildeten Halbleiterbausteinen HBI bis HBIV zu Ausgangssignalen verknüpft, die dann für die weitere Steuerung zur Verfügung stehen. Die Ableitung dieser Ausgangssignale durch die Halbleiterbausteine und deren Beschaltung sei nun im nachfolgenden näher erläutert.

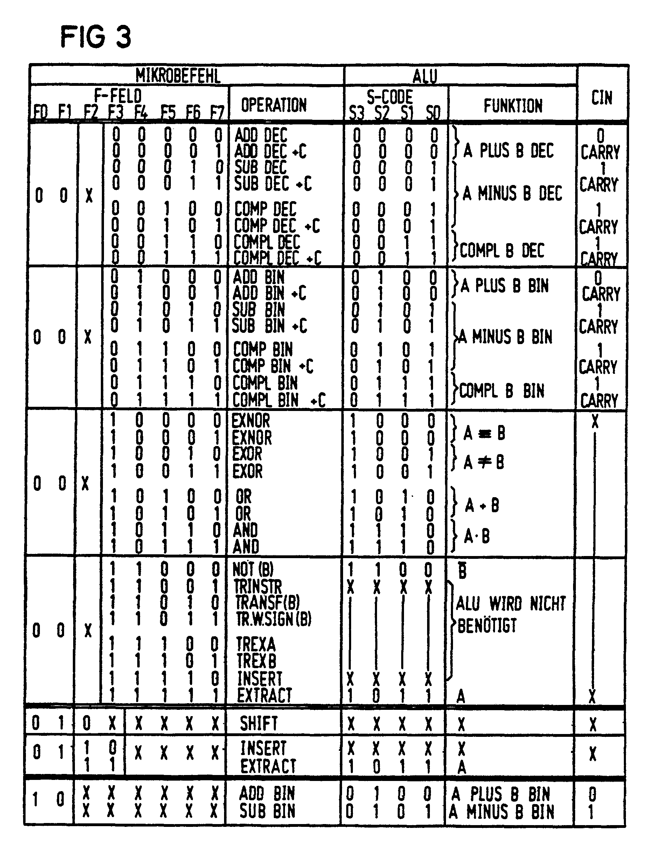

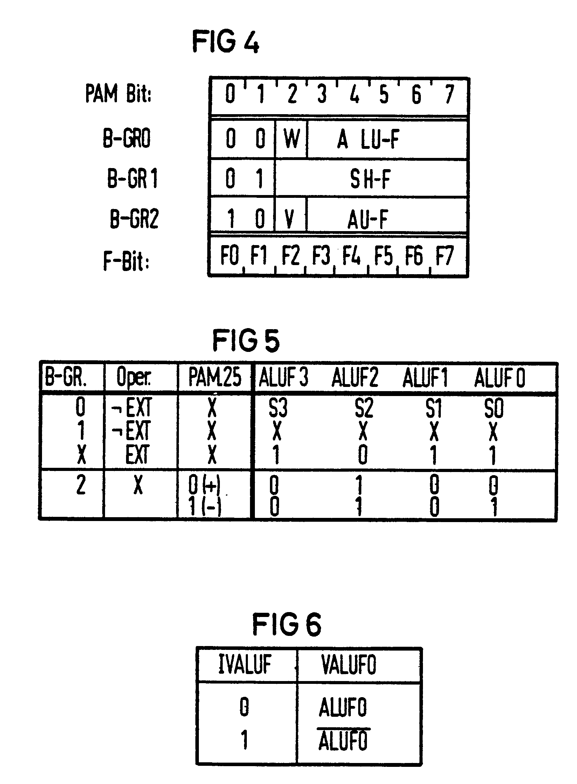

Die Tabelle von FIG 3 zeigt zu diesem Zweck in ihrem linken Teil die Liste aller möglichen Mikrobefehle mit ihrer Funktionsangabe und im rechten Teil den Steuercode (S-Code) mit der entsprechenden Funktionsangabe für die verwendete ALU sowie die Angabe für den jeweils benötigten Eingangsübertrag CIN. Diese Tabelle ist maßgebend für die Ableitung der Steuersignale ALUF für die ALU in FIG 2 abhängig von den sieben Steuerbits F0 bis F7 im F-Feld des Befehlsregisters PAM. Anhand der Steuerbit F0 und F1 lassen sich drei verschiedene Befehlsgruppen unterscheiden, die in der Tabelle von FIG 4 wiedergegeben sind. Wie aus der Tabelle von FIG 3 weiterhin ersichtlich ist, ist die Ableitung des S-Codes für die Befehlsgruppe B-GR0 mit Ausnahme für die Operation EXTRACT unmittelbar anhand der Steuerbits F3 bis F6 möglich. Dies gilt jedoch nicht für die Extract-Operation, da diese sowohl in der Befehlsgruppe B-GR0 als auch in der Befehlsgruppe B-GR1 auftaucht und die Ableitung des entsprechenden S-Codes von zwei vollkommen unterschiedlich gearteten F-Bit-Kombinationen abhängig ist, und außerdem auch nicht für die Operationen der Befehlsgruppe B-GR2, da in diesem Falle die ALU eine Adressenmodifikation durchführt, wobei die Modifikationsrichtung vom Bit 25 des Befehlsregister PAM abhängig ist. Dieser Zusammenhang ist in der Tabelle von FIG 5 wiedergegeben, wobei sich der linke Teil der Tabelle auf die drei Steuergrößen, nämlich Befehlsgruppe B-GR0 bis 2, die Operation EXTRACT und das Bit PAM25 bezieht. Der rechte Teil der Tabelle bezieht sich auf die entsprechend den vier Stellen des S-Codes zu bildenden Ausgangssignale ALUF0 bis ALUF3 für die Steuerung der ALU-Funktion. In der ersten Zeile entsprechen die Ausgangssignale unmittelbar den korrespondierenden Stellensignalen S0 bis S3 des S-Codes. Bei Transfer-Funktionen der Gruppe B-GR0 und sonstigen Funktionen der Gruppe B-GR1 können die Steuersignale für die ALU einen beliebigen Wert haben, da die ALU in diesem Falle nicht berücksichtigt wird. Unabhängig von der Befehlsgruppe B-GR führt die Operation EXT zu der gewünschten Ausganssignalkombination. Analoges gilt für die Gruppe B-GR2 abhängig vom Bit PAM 25.

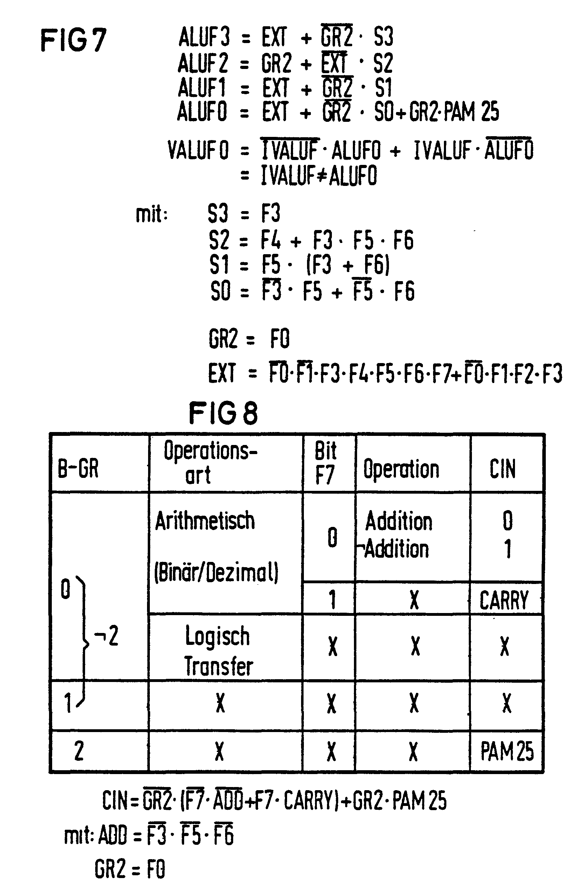

Die sich aufgrund dieser Wahrheitstabelle ergebenden Verknüpfungsformeln für die Ausgangssignale ALUF0 bis ALUF3 zur Steuerung der ALU-Funktion sind in FIG 7 zusammengestellt, wobei sich die Zwischenverknüpfungsgrößen S0 bis S3, GR2 und EXT unmittelbar anhand der Tabelle von FIG 3 aus den Steuersignalen F0 bis F7, wie angegeben, herleiten lassen.

Um des weiteren die Forderung zu erfüllen, daß das Signal ALUF0 abhängig von einem zusätzlichen Steuersignal IVALUF für Wartungszwecke auch invertiert angeboten wird, enthält die Zusammenstellung von FIG 7 eine weitere Verknüpfungsformel für das

entsprechende Signal VALUF0, die sich aufgrund der in FIG 6 dargestellten Wahrheitstabelle herleiten läßt.

Für die Ableitung des zur Steuerung der ALU weiterhin benötigten Eingangsübertrages CIN ergeben sich aus der Tabelle nach FIG 3 folgende Randbedingungen:

Das Signal CIN wird von der ALU nur bei arithmetischen Operationen, also wenn F3 gleich Null ist, berücksichtigt. In allen anderen Fällen kann es einen beliebigen Wert aufweisen.

Der einzustellende Wert für CIN ist von der auszuführenden ALU-Operation abhängig, d.h. bei einer Addition wird CIN zu Null und bei einer Subtraktion zu Eins, wenn nicht Bit F7 = 1 die Verwendung des zwischengespeicherten Ausgangsübertrages CARRY der ALU beim vorhergehenden Operationsschritt als Ausgagssignal CIN erzwingt.

In der Gruppe B-GR1 kann das Signal CIN einen beliebigen Wert aufweisen, da das ALU-Ergebnis nicht berücksichtigt wird.

Bei der Gruppe B-GR2 ist das Signal CIN ähnlich wie die auszuführende ALU-Operation von der Modifikationsrichtung, d.h. vom Bit PAM25, abhängig und entspricht direkt dem Signal dieses Bit.

In FIG 8 sind diese Randbedingungen tabellarisch zusammengestellt und die sich daraus ableitbare Verknüpfungsformel für das Ausgangssignal CIN angegeben. Die dabei benötigten Zwischengrößen ADD und GR2 sind wiederum unmittelbar anhand der Tabelle von FIG 3 aus den F-Signalen herleitbar.

Die in FIG 7 und FIG 8 zusammengestellten sechs Ausgangssignale mit ihren Verknüpfungsformeln erfordern jeweils eine eigene Logikschaltung im Halbleiterbaustein, die entsprechend der jeweiligen Verknüpfungsformel ausgebildet ist. Mit Bezug auf FIG 1 sind dies die Logikschaltungen LSi1 bis LSi6, wobei in Anlehnung an FIG 7 die benötigte Zwischengröße EXT durch die vorangehende Teillogikschaltung T-LSi nur einmal gebildet und den nachfolgenden Restlogikschaltungen als zusätzliche Eingangsgröße zugeführt wird. Für die insgesamt sechs Signale zur Steuerung der ALU sind nur drei Ausgangsklemmen auf dem Halbleiterbaustein vorgesehen. Das setzt zur Realisierung wenigstens zwei Halbleiterbausteine voraus, wobei durch die nachgeschalteten Auswahlschaltglieder AW-A bis AW-C abhängig von dem zugeführten Steuersignal 0 oder 1 an der Eingangsklemme STCO jeweils drei Ausgangssignale an jedem der beiden Halbleiterbausteine zur Verfügung gestellt werden.

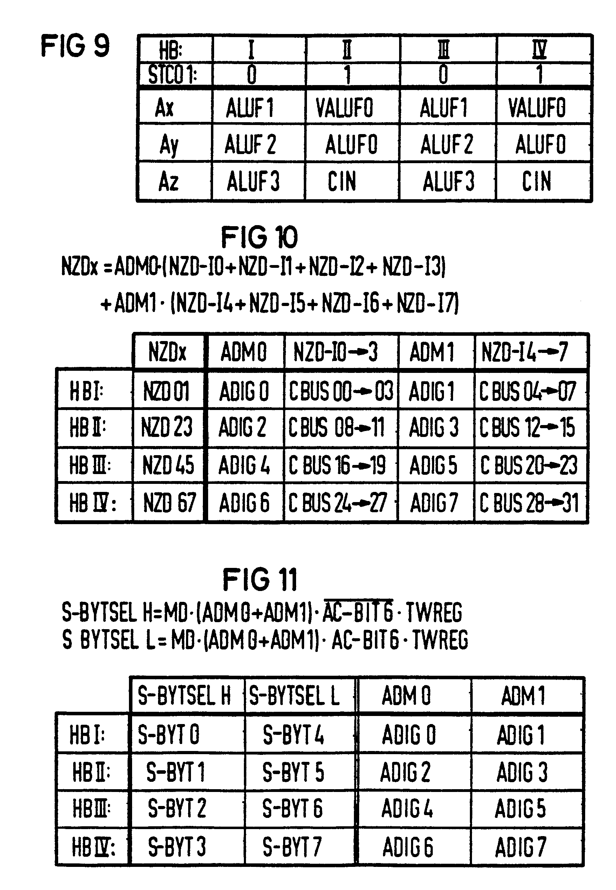

Im vorliegenden Falle sei jedoch davon ausgegangen, daß insgesamt vier gleichartig ausgebildete Halbleiterbausteine zur Verfügung stehen. In diesem Falle würden je Halbleiterbausteine zwei Ausgangsklemmen ausreichen, wobei insgesamt acht Ausgangssignale abgegeben werden könnten. Beim vorliegenden Ausführungsbeispiel sind jedoch trotz der vier gleichartigen Halbleiterbausteine je Halbeiterbaustein drei Ausgangsklemmen wie beim Ausführungsbeispiel gemäß FIG 1 vorgesehen, so daß jedes Signal an zwei verschiedenen Halbleiterbausteinen parallel zur Verfügung gestellt werden kann. Die sich dabei ergebende Signalverteilung ergibt sich aus der Tabelle nach FIG 9. Jeder Halbleiterbaustein HBI bis HBIV weist drei Ausgangsklemmen Ax bis Az auf, wobei die Einstellung der zugehörigen Auswahlschaltglieder anhand des Steuersignals STCO 1 erfolgt.

Danach liefern die Halbleiterbausteine HBI und HBIII sowie HBII und HBIV an den aneinander korrespondierenden Ausgangsklemmen jeweils die gleichen Signale. Das hat den Vorteil, daß parallel zu der einen ALU zugleich eine in vielen Fällen vorhandene Vergleichs-ALU mit unabhängigen Signalen angesteuert werden kann. Außerdem besteht unabhängig davon, ob zusätzlich eine Vergleichs-ALU zu steuern ist, die einfache Möglichkeit, durch einfachen Vergleich der parallelen Ausgangssignale, die Arbeitsweise der Steuerung PU-ST wenigstens teilweise zu sichern.

Eine weitere Aufgabe der Steuereinrichtung PU-ST besteht darin, aus von der ALU gelieferten Signalen die bei arithmetischen und logischen Operationen benötigten Anzeigen über das Ergebnis abzuleiten. Eine dieser Anzeigen ist die "Ergebnis-nicht-gleich-Null"oder abgekürzt NZD-Anzeige. Diese Anzeige wird bekanntlich durch eine ODER-Verknüpfung aller gültigen Bits des ALU-Ergebnisses gewonnen. Bei einer Ergebnisbreite von insgesamt 32 Bit für die ALU entsprechend 8 Digit zu je 4 Bit sind maximal 40 Signale miteinander zu verknüpfen und damit bei Aufteilung auf vier gleiche Halbleiterbausteine 10 Signale je Halbleiterbaustein, nämlich jeweils die Bitsignale von zwei Digits und die beiden dazugehörigen Gültigkeitssignale. Die entsprechende Verknüpfungsformel für das dem jeweiligen Teilergebnis NZDx entsprechende Ausgangssignal ist in FIG 10 mit Bezug auf die dafür vorgesehenen Eingangsklemmen wiedergegeben, wobei ADM 0 und ADM 1 die Eingangsklemmen für die beiden Gültigkeitssignale und NZD-I 0 bis NZD-I 7 die acht Eingangsklemmen für jeweils acht Ergebnisbit der ALU kennzeichnen. Die in FIG 10 weiterhin gezeigte Tabelle zeigt die Belegung der einzelnen Eingangsklemmen je Halbleiterbaustein HBI bis HBIV mit den verschiedenen Signalen und die an den einzelnen Halbleiterbausteinen gewonnenen Teilsignale NZDx, die dann durch eine weitere ODER-Verknüpfung zum Gesamtsignal NZD der ALU führen. Je Halbleiterbaustein wird also lediglich eine einzige Logikschaltung, im Ausführungsbeispiel gemäß FIG 1 die Logikschaltung LSz, für nur ein Viertel der insgesamt notwendigen Verknüpfungen benötigt, d.h. der gesamte Verknüpfungsaufwand ist also gleichmäßig auf die einzelnen Halbleiterbausteine HBI bis HBIV verteilt, so daß an den korrespondierenden Ausgangsklemmen Ausgangssignale homogener Struktur entstehen.

Ein weiteres Beispiel für die Bildung von Ausgangssignallen homogener Struktur sei anhand von FIG 11 erläutert, wobei jedoch im Gegensatz zum vorhergehenden Beispiel nur ein Teil der zu verknüpfenden Eingangsvariablen oder Eingangssignale unterschiedlich ist. Es handelt sich hierbei um Steuersignale für die Speicheransteuerung zur Auswahl einzelner Byte aus einem Speicherwort. Dabei sei unterstellt, daß jedes Speicherwort aus einem Doppelwort zu je vier Byte, also aus insgesamt acht Byte besteht und jedes Byte getrennt auswählbar sein soll. Dafür sind insgesamt acht Steuersignale erforderlich, die in zwei Gruppen zu je vier Steuersignalen zusammengefaßt sind, wobei sich die eine Gruppe auf die eine Doppelworthälfte und die andere Gruppe auf die andere Doppelworthälfte bezieht. Maßgebend für die Ableitung der Byte-Auswählsignale ist dabei zunächst einmal, daß der Speicher und damit die zuständigen Speicherdatenregister überhaupt anzusteuern sind. Dies wird durch das vom Decoder DEC in FIG 2 gelieferte Steuersignal MD angezeigt. Weiterhin ist zu berücksichtigen, ob das jeweilige Byte gültig ist. Dies ergibt sich aus den bereits anhand des Beispieles zu FIG 10 behandelten Gültigkeitssignalen für die einzelnen Digits, wobei jeweils zwei Digits ein Byte bilden. Weiterhin ist maßgebend, welche Doppelworthälfte betroffen ist, was von dem ebenfalls vom Decoder DEC in FIG 2 gelieferten Signal AC BIT6 angezeigt wird, und daß wegen der direkten Ergebnisübernahme die Auswahlsignale nur synchron mit dem Ergebnistakt für die Register bereitgestellt werden darf.

Damit ergeben sich die in FIG 11 dargestellten beiden Verknüpfungsformeln, nämlich für die Ausgangsklemme S-BYTSEL H mit Bezug auf die eine Speicher-Doppelworthälfte und für die Ausgangsklemme S-BYTSEL L mit Bezug auf die andere Speicher-Doppelworthälfte. Auch in diesem Falle beziehen sich die Verknüpfungsgrößen auf die Eingangsklemmen, wobei die Eingangssignale an den Eingangsklemmen MD, AC-BIT6 und TWREG für alle Halbleiterbausteine gleich sind, während die Signale an den Eingangsklemmen ADM0 und ADM1 entsprechend den verschiedenen zu berücksichtigenden Digits des ALU-Ergebnisses von Halbleiterbaustein zu Halbleiterbaustein sich ändern. Die an den beiden Ausgangsklemmen der einzelnen Halbleiterbausteine HBI bis HBIV gewonnenen Ausgangssignale S-BYT0 bis 7 und die Belegung der Eingangsklemmen ADM0 und ADM1 mit den verschiedenen Gültigkeitssignalen ADIG0 bis ADIG7 ergeben sich aus der in FIG 11 ebenfalls gezeigten Tabelle. Die dementsprechend je Baustein benötigten Logikschaltungen sind in FIG 1 mit LSx und LSy bezeichnet. Auch in diesem Falle ist der Verknüpfungsaufwand gleichmäßig auf die vier verschiedenen Halbleiterbausteine verteilt.

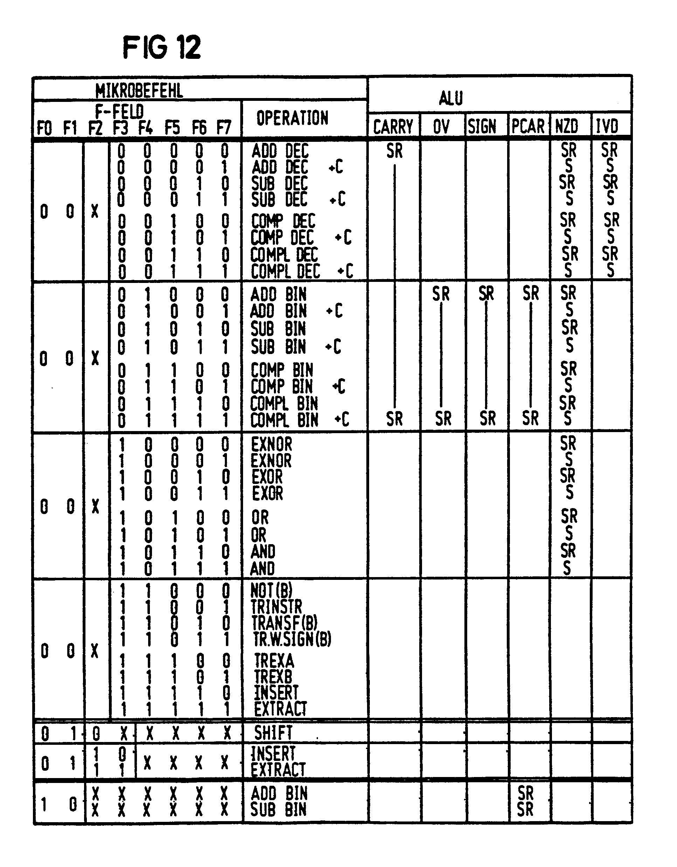

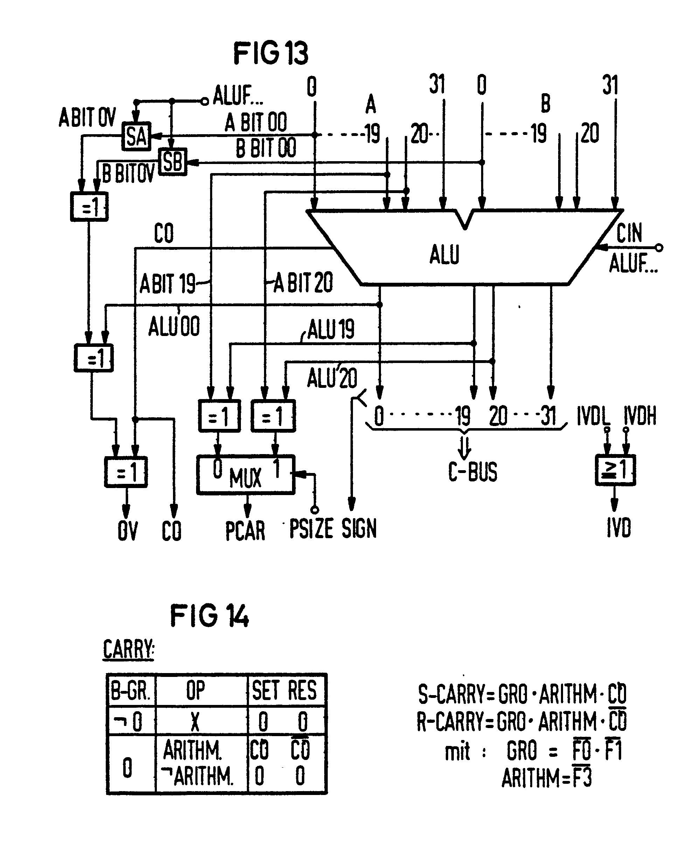

Ein weiteres Beispiel für die Ableitung von Ausgangssignalen inhomogener Struktur bezieht sich auf die Steuerung der ALU-Anzeigen, die in zwei Schritte zerfällt, nämlich die Ableitung der Anzeigen aus den ALU-Signalen und dem Setzen der Anzeigen in einem Register. Dabei läuft die Ableitung der Anzeigen bekanntlich immer parallel zur ALU ab, gleichgültig, ob alle Anzeigen aktuell oder sinnvoll sind. Das Setzen der Anzeigen ist dagegen von der jeweils ausgeführten Operation abhängig. Den Zusammenhang zwischen den einzelnen ALU-Anzeigen und den verschiedenen ALU-Operationen zeigt die Tabelle von FIG 12. Danach sind insgesamt sechs ALU-Anzeigen vorgesehen, nämlich die Anzeige CARRY als Übertrag aus der höchstwertigen Ergebnisstelle bei einer arithmetischen Operation, die Anzeige OV als Überlauf, die Anzeige SIGN als Ergebnisvorzeichen, die Anzeige PCAR als Seitenüberlauf beim Übertrag aus einer Seite, die Anzeige NZD für den Fall, daß das Ergebnis nicht gleich Null ist, und die Anzeige IVD beim Vorliegen einer ungültigen Dezimalziffer bei den im Rahmen einer Dezimaloperation zu verknüpfenden beiden Operanden. Die Buchstaben S und R kennzeichnen dabei in den Spalten für die einzelnen Anzeigen, ob die jeweilige Anzeige gesetzt oder zurückgesetzt werden muß. Die Setz- bzw. Rücksetzbedingungen für die einzelnen ALU-Anzeigen lassen sich daher in einfacher Weise abhängig von den jeweils durchzuführenden Operationen der ALU aus der Tabelle anhand der von der ALU bei der jeweiligen Operation jeweils gelieferten Steuersignale ableiten. Ein Teil dieser Steuersignale wird dabei nicht unmittelbar geliefert, sondern durch zusätzliche Verknüpfungsschaltungen der Halbleiterbausteine HBI bis HBIV der Steuereinrichtung PU-ST anhand von Hilfssignalen der ALU ermittelt, wie FIG 13 zeigt.

Das den Übertrag aus der höchstwertigen Ergebnisstelle kennzeichnende Steuersignal CO wird von der ALU unmittelbar zur Verfügung gestellt. Analoges gilt für das Steuersignal SIGN für die SIGN-Anzeige. Das den Überlauf kennzeichnende Steuersignal OV muß dagegen erst abgeleitet werden. Bekanntlich liegt ein Überlauf dann vor, wenn der Übertrag in das höchstwertige Bit nicht gleich dem Übertrag aus dem höchstwertigen Bit ist. Dies kann man ohne Eingriff in die ALU dadurch feststellen, daß man die höchstwertigen Bit beider Operanden A und B, also ABITOO und BBITOO unmittelbar miteinander vergleicht. Sind sie ungleich, so ist die Summe immer eine "1" sind sie gleich, so ist die Summe immer eine "0". Stimmt weiterhin das höchstwertige Ergebnisbit ALUOO der ALU nicht mit dieser Summe überein, so hat ein Übertrag in die letzte Bitstelle vorgelegen. Für die Ableitung dieses Übertrags sind also zwei exklusive ODER-Glieder erforderlich, sowie ein weiteres exklusives ODER-Glied für die Ableitung des endgültigen Steuersignales OV aus dem Übertrag in die letzte Bitstelle und aus dem Übertrag CO aus der letzten Bitstelle der ALU. Abweichend von diesen grundsätzlichen Überlegungen zur Ableitung des den Überlauf kennzeichnenden Steuersignals OV ist jedoch zu berücksichtigen, daß bei einigen Operationsfunktionen die ALU vor der eigentlichen Operandenverknüpfung beide bzw. einen der Operanden zusätzlich bearbeitet. So wird z. B. bei einer Subtraktion SUB der B-Operand vorher negiert, während bei der Complementbildung COMPL der A-Operand zu Null gesetzt wird. Die höchstwertigen Bit beider Operanden A und B, also ABITOO und BBITOO, unterliegen daher zusätzlich Änderungen abhängig von der jeweils auszuführenden ALU-Funktion ALUF..., die durch die Schaltglieder SA und SB gesteuert werden, deren Ausgangssignale ABITOV und BBITOV dann in der obengenannten Weise zu verknüpfen sind.

Für die Ableitung des Steuersignals PCAR ist unterstellt, daß abhängig von dem Steuersignal PSIZE, ein Überschreiten der zulässigen Seitengrenze dann vorliegt, wenn ein Übertrag in das Bit 20 bzw. 19 auftritt. Dieser Übertrag wird in einfacher Weise durch Vergleich der Bit 19 bzw. 20 des Operanden A mit dem entsprechenden Bit 19 bzw. 20 des ALU-Ergebnisses mit Hilfe jeweils eines exklusiven ODER-Gliedes ermittelt, wobei die Ungleichheit der verglichenen Signale das Vorliegen eines Übertrages anzeigt.

Das Steuersignal NZD wird, wie bereits anhand von FIG 10 erläutert worden ist, von den Ergebnissignalen der ALU in Verbindung mit Gültigkeitssignalen für die einzelnen Digits abgeleitet. Die dabei gewonnenen Teilsignale NZD01, NZD23, NZD45 und NZD67 werden durch ein ODER-Glied miteinander verknüpft und liefern dann das benötigte Steuersignal NZD.

Weiterhin sei unterstellt, daß das Steuersignal IVD zur Kennzeichnung einer ungütigen dezimalen Codierung für ein Digit aus zwei Gruppensignalen IVDL und IVDH für jeweils eine Gruppe von Digits durch eine ODER-Verknüpfung abzuleiten ist.

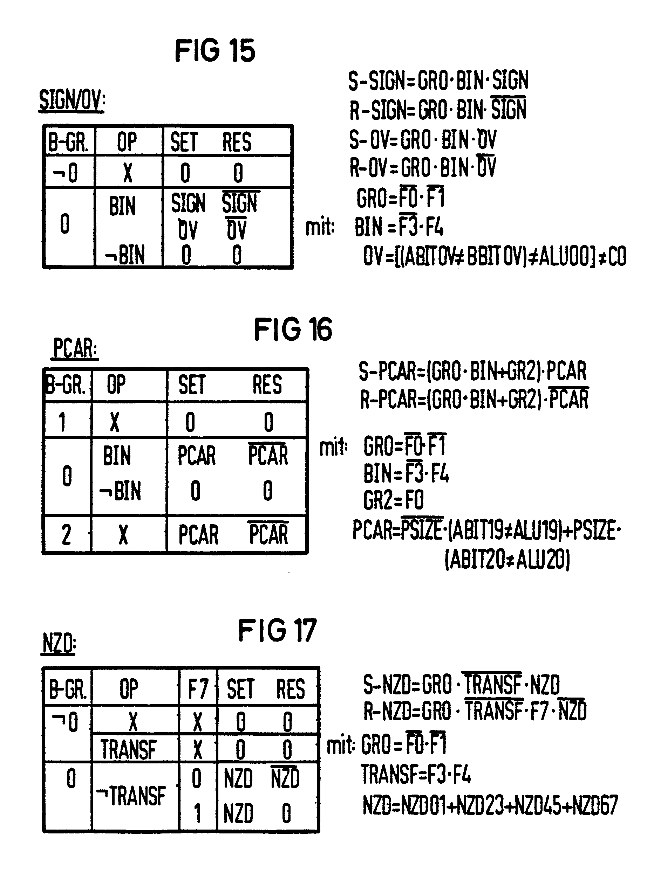

Aufgrund dieser anhand der FIG 13 ableitbaren Steuersignale seien nachfolgend anhand von FIG 14 bis FIG 18 die sich aus der Tabelle von FIG 12 ergebenden Setzbedingungen und die sich daraus ergebenden Verknüpfungsformeln für die einzelnen ALU-Anzeigenbefehle erläutert. Dabei sei unterstellt, daß sowohl die Setzsignale als auch die Rücksetzsignale aktive Signale sind und beide Signale für ein und dieselbe Anzeige nicht gleichzeitig auftreten. Außerdem erfolgt die Verknüpfung mit dem entsprechenden Steuertakt innerhalb des Verarbeitungszyklus außerhalb der einzelnen Halbleiterbausteine.

Gemäß FIG 14 werden die Anzeigensignale S-CARRY und R-CARRY nur bei arithmetischen Operationen der Befehlsgruppe B-GRO abhängig vom Steuersignal CO gebildet, wobei die Zwischenverknüpfungsgrößen für die Befehlsgruppe GRO und die arithmetische Operation ARITHM sich aus den zugehörigen F-Signalen des Mikrobefehls anhand von FIG 12 ergeben, während das Steuersignal CO unmittelbar von der ALU zur Verfügung gestellt wird.

Gemäß FIG 15 ergeben sich die Setz- und Rücksetzsignale S-SIGN bzw. R-SIGN und S-OV bzw. R-OV für die ALU-Anzeigen SIGN und OV gemäß der gezeigten Tabelle lediglich bei binären Operationen in der Befehlsgruppe B-GRO abhängig von den entsprechenden Steuersignalen SIGN bzw. $\overline{\text{SIGN}}$ und OV bzw. $\overline{\text{OV}}$. Die wiederum benötigten Zwischengrößen GRO und BIN sind anhand der Tabelle von FIG 12 aus den F-Signalen herleitbar, während das Steuersignal SIGN von der Prozessoreinrichtung PU mit der ALU in FIG 2 unmittelbar zur Verfügung gestellt wird und das Steuersignal OV entsprechend FIG 13 in der bereits beschriebenen Weise abgeleitet werden muß, wobei unterstellt ist, daß die Zwischengrößen ABIT OV und BBIT OV außerhalb der Halbleiterbausteine nach folgenden Verknüpfungsformeln gebildet werden:

$$\text{ABITOV} = \overline{\text{COMPL}} \cdot \text{ABITOO}$$

$$\text{mit COMPL} = \text{F5} \cdot \text{F6}$$

$$\text{BBITOV} = \text{SUB} \neq \text{BBITOO}$$

$$\text{mit SUB} = \overline{\text{F5}} \cdot \text{F6}$$

FIG 16 bezieht sich auf die Verknüpfungsformeln für die Anzeigensignale S-PCAR und R-PCAR für die ALU-Anzeige PCAR und die diesen Verknüpfungsformeln zugrundeliegende Entscheidungstabelle. Beide Anzeigensignale können sowohl bei einer Binäroperation der Befehlsgruppe B-GR0 als auch bei einer Operation innerhalb der Befehlsgruppe B-GR2 unabhängig von der Art der Operation abhängig vom Steuersignal PCAR auftreten. Bei allen übrigen Operationen sind die Anzeigensignale gleich Null. Das Steuersignal PCAR muß, wie bereits anhand von FIG 13 erläutert worden ist, entsprechend der angegebenen Verknüpfungsformel gebildet werden.

FIG 17 zeigt die Entscheidungstabelle zur Ableitung der Verknüpfungsformeln für die Anzeigensignale S-NZD und R-NZD für die ALU-Anzeige NZD. Diese Anzeigensignale können lediglich in der Befehlsgruppe B-GR0 bei Nicht-Transferoperationen auftreten, wobei die Bildung des Anzeigensignales R-NZD zusätzlich vom Signal F7 abhängig ist. Das außerdem benötigte Steuersignal NZD ergibt sich aus den bereits anhand von FIG 10 erläuterten Teilsignalen NZD01, NZD23, NZD45 und NZD67 der verschiedenen Halbleiterbausteine HBI bis HBIV nach der angegebenen Verknüpfungsformel.

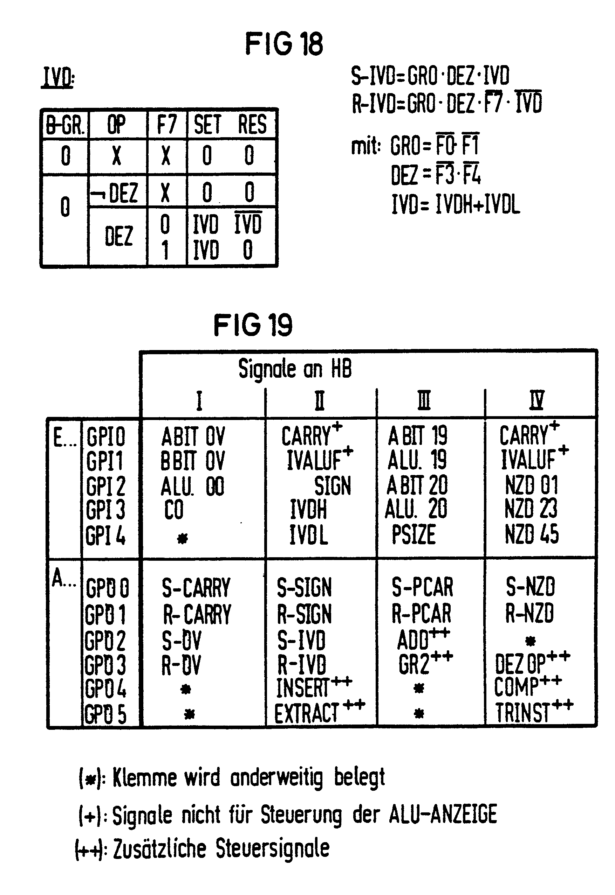

Schließlich gibt FIG 18 die Verknüpfungsformeln für die Anzeigensignale S-IVD und R-IVD für die ALU-Anzeige IVD zusammen mit der zugrundeliegenden Entscheidungstabelle wieder. Danach werden diese Signale lediglich bei einer Dezimaloperation in der Befehlsgruppe B-GR0 gebildet, wobei für das Signal R-IVD zusätzlich das Signal F7 des Mikrobefehlscodes maßgebend ist. Das benötigte Steuersignal IVD ergibt sich, wie ebenfalls bereits anhand von FIG 13 erläutert, aus der ODER-Verknüpfung der beiden Gruppensignale IVDH und IVDL.

Insgesamt sind so 10 verschiedene Anzeigensignale inhomogener Struktur zu bilden, die zehn individuelle Logikschaltungen erfordern. Diese Logikschaltungen sind auf jedem der für die Steuereinrichtung PU-ST in FIG 2 benötigten Halbleiterbausteine HBI bis HBIV vorzusehen, wobei nachgeschaltete Auswahlschaltglieder AW, wie in FIG 1 angedeutet, je Halbleiterbaustein ein unterschiedliches Ergebnissignal auswählen. Unterstellt man dabei, daß die Setz- und Rücksetzsignale für ein- und dieselbe ALU-Anzeige jeweils von ein- und demselben Halbleiterbaustein geliefert werden sollen, so sind insgesamt vier Ausgangsklemmen für die zwölf Ausgangssignale erforderlich. Diesen zwölf Ausgangssignalen stehen neben den F-Signalen des Mikrobefehlscodes sechzehn zusätzliche Eingangssignale gegenüber, die für die Bildung der Ausgangssignale erforderlich sind. Die meisten Eingangssignale, nämlich fünf, erfordern dabei die Anzeigensignale S-PCAR und R-PCAR, die gleichzeitig über Eingangsklemmen zur Verfügung gestellt werden müssen. Durch geeignete Verteilung der einzelnen zu bildenden Ausgangssignale auf die verschiedenen Halbleiterbausteine HBI bis HBIV läßt sich die Zahl der je Halbleiterbaustein benötigten Eingangssignale dadurch herabsetzen, daß jedem Halbleiterbaustein nur die Eingangssignale zugeführt werden, die für die Bildung der ausgewählten Ausgangssignale erforderlich sind. Auf diese Weise brauchen je Halbleiterbaustein nur so viele Eingangsklemmen aufgewendet werden, wie Eingangssignale erforderlich sind. Im vorliegenden Falle sind also fünf Eingangsklemmen je Halbleiterbaustein für die Zuführung der zusätzlichen Steuersignale bei der Bildung der ALU-Anzeigensignale erforderlich.

FIG 19 zeigt die Verteilung der einzelnen Steuersignale an den verschiedenen Halbleiterbausteinen HBI bis HBIV auf die fünf verschiedenen Eingangsklemmen GPI0 bis GPI4, sowie die entsprechende Belegung der Ausgangsklemmen GPO0 bis GPO3. Da gemäß FIG 14 und FIG 15 das Steuersignal CO sowohl für die CARRY- als auch für die OV-Anzeige benötigt wird, sind die Anzeigensignale für diese beiden Anzeigen auf einem Halbleiterbaustein HBI zusammengefaßt, so daß für die zusätzlichen Steuersignale lediglich die Eingangsklemmen GPI0 bis GPI3 benötigt werden. Andererseits erfordern die Anzeigensignale für die Anzeige PCAR für sich allein fünf Steuersignale, so daß eine Kopplung mit weiteren Anzeigensignalen auf ein- und demselben Halbleiterbaustein nicht möglich ist. Im vorliegenden Falle ist hierfür der Halbleiterbaustein HBIII vorgesehen. Für die Verteilung der restlichen Anzeigensignale auf die beiden restlichen Halbleiterbausteine ist ein größerer Freiheitsgrad gegeben. Man könnte einerseits die Anzeigensignale für die Anzeige NZD und auch SIGN auf einem Halbleiterbaustein zusammenfassen, da nach FIG 15 für die Bildung der Anzeige SIGN nur ein Steuersignal und für die Anzeige NZD gemäß FIG 17 vier Steuersignale erforderlich sind. Tatsächlich werden hierfür aber nur drei Steuersignale NZD01, NZD23 und NZD45 benötigt, wenn hierfür der Halbleiterbaustein HBIV vorgesehen wird, da gemäß FIG 10 das weiterhin benötigte Steuersignal NZD67 auf diesem Halbleiterbaustein gebildet wird und somit nicht mehr von außen zugeführt zu werden braucht. Auf dem Halbleiterbaustein HBIV werden also nur drei Eingangsklemmen für die Bildung der Anzeige NZD benötigt. Ebenso werden nur drei Eingangsklemmen für die erforderlichen Steuersignale benötigt, wenn man die Anzeigen SIGN und IVD auf einem Baustein zusammenfaßt. Im vorliegenden Falle ist hierfür der Halbleiterbaustein HBII vorgesehen. Damit bleiben sowohl am Halbleiterbaustein HBII und HBIV zwei Eingangsklemmen, im vorliegenden Falle die Eingangsklemmen GPI0 und GPI1 frei, so daß Platz geschaffen wird für die Eingangssignale CARRY und IVALUF, die gemäß FIG 9 für die Ausgangssignale VALUFO gemäß FIG 7 und CIN gemäß FIG 8 an beiden Halbleiterbausteinen HBII und HBIV für die Bildung gleicher paralleler Signale zu Sicherungszwecken benötigt werden. In gleicher Weise können auch die frei gebliebenen Ausgangsklemmen GPO2 und GPO3 der Halbleiterbausteine HBIII und HBIV für zusätzliche Ausgangssignale ausgenutzt werden. Im vorliegenden Falle handelt es sich um die Signale ADD, GR2 und DEZOP, die unmittelbar aus den an allen Halbleiterbausteinen zu eführten F-Signalen des Mikrobefehlscodes gemäß FIG 3 abgeleitet werden können, so daß keine zusätzlichen Eingangssignale an den Eingangsklemmen GPI0 bis GPI4 erforderlich sind. Analoges gilt für die zusätzlich vorgesehenen Ausgangsklemmen GPO4 und GPO5 der verschiedenen Halbleiterbausteine. Insgesamt können somit über eine begrenzte Zahl von Eingangsklemmen den einzelnen Halbleiterbausteinen verschiedene Signale zugeführt werden, da durch die den Logikschaltungen LSI7 bis LSIn in FIG 1 nachgeschatteten Auswahlschaltglieder AW-K bis AW-P jeweils nur die Ergebnissignale der Logikschaltungen als Ausgangssignale freigegeben werden, für die die jeweils angelegte Kombination von Eingangssignalen auch bestimmt ist.

Außerdem können, wie bereits im Zusammenhang mit FIG 7 und FIG 1 erläutert, übereinstimmende Zwischengrößen für mehrere Logikschaltungen LSi durch eine vorausgehende gemeinsame Teillogikschaltung ermittelt werden. Diese gilt z. B. für die Ableitung der Steuersignale S-SIGN, R-SIGN, S-OV, R-OV, S-PCAR und R-PCAR mit Bezug auf die gemeinsame Teilgröße GRO · BIN bzw. die erforderlichen exklusiven ODER-Verknüpfungen gemäß FIG 15 und FIG 16.

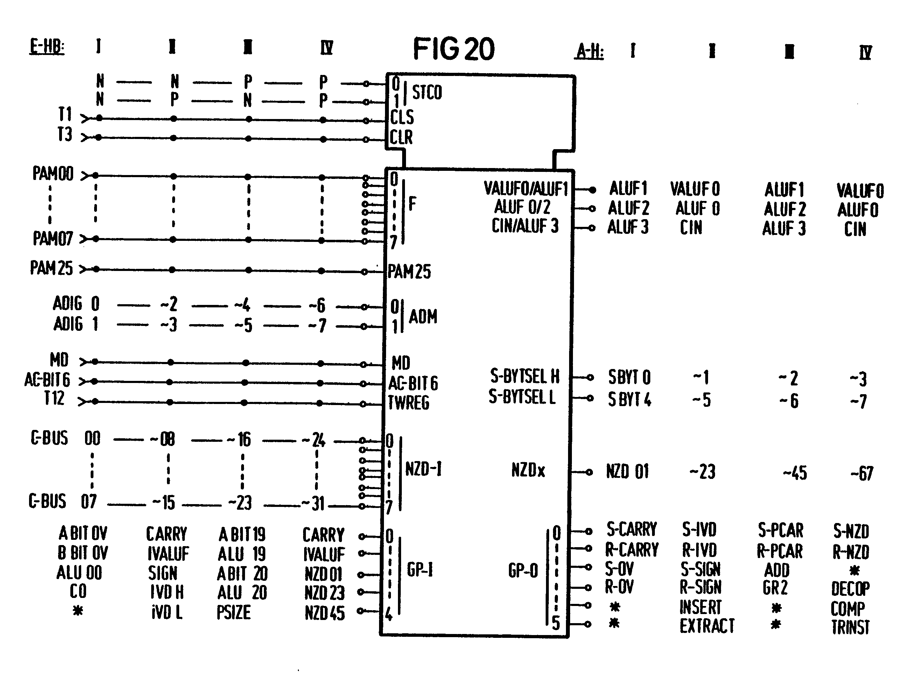

FIG 20 zeigt schließlich die Klemmenverteilung des in FIG 1 gezeigten Halbleiterbausteines mit Bezug auf die vorangehend abgeleiteten Verknüpfungsformeln, die in dem Halbleiterbaustein in integrierter Schaltkreistechnik realisiert sind, und die verschiedenen Eingangs- und Ausgangssignale für die korrespondierenden Bausteinklemmen der verschiedenen Halbleiterbausteine HBI bis HBIV. Der gezeigte Baustein gliedert sich in einen Steuerblock mit den Eingangsklemmen STCO-0 und STCO-1 für die Einstellung der Auswahlschaltglieder AW gemäß FIG 1, wobei durch die jeweils zugeführte Eingangssignalkombination festgelegt wird, als welcher von den vier möglichen Halbleiterbausteinen HBI bis HBIV der jeweilige Baustein arbeitet. Die weiteren gemeinsamen Steuerklemmen CLS und CLR dienen zur Taktung des in FIG 1 gezeigten Zwischenspeichers für die aus dem Mikrobefehlswort abgeleiteten Steuersignale, beispielsweise in der Art, daß mit dem ersten Takt T1 eines Arbeitszyklus der Zwischenspeicher freigegeben und mit dem dritten Takt T3 wieder gesperrt wird, so daß Änderungen der Eingangssignale PAM... während des restlichen Arbeitszyklusses nicht auf den Zwischenspeicher ZSP durchschlagen können. Die Verknüpfung der einzelnen Eingangsklemmen auf der linken Seite des Halbleiterbausteines mit den Ausgangsklemmen auf der rechten Seite des Halbleiterbausteines sind im übrigen durch die vorangehend abgeleiteten Verknüpfungsformeln vorgegeben.

Selbstverständlich kann der gezeigte Halbleiterbaustein über die erläuterten Verknüpfungsfunktionen hinaus bei zusätzlichen Eingangs- und Ausgangsklemmen auf weitere Verknüpfungsfunktionen ausgedehnt sein, die sich aus dem speziellen Einsatzfall ergeben. Insgesamt zeigt das gewählte Ausführungsbeispiel, wie ausgehend von dem Grundgedanken der Erfindung auch wahlfreie Logikteile, insbesondere für Rechnersteuerungen, mit Einheitsbausteinen verwirklicht werden können.

**Patentansprüche**

1. Logische Verknüpfungsanordnung, bestehend aus mehreren gleichartigen Halbleiterbausteinen in hochintegrierter Schaltkreistechnik, gekennzeichnet
- durch wenigstens eine Gruppe von gleichartigen Logikschaltungen (z. B. LSx und LSy bzw. LSz) mit einheitlich vorgegebener Verknüpfungsfunktion zur Bildung gleichartiger, einer Signalgruppe homogener Struktur engehörender Ausgengssignale (Ausgangssignale homogener Struktur S-H), wobei die benötigten Logikschaltungen jeder Gruppe gleichmäßig auf die Halbleiterbausteine (z. B. HBI bis HBIV) verteilt sind,
- durch wenigstens eine Gruppe von Logikschaltungen (LSi....), die jeweils unterschiedliche Verknüpfungsfunktionen ausführen und entspechend unterschiedlich gebildete, wenigstens einer Signalgruppe inhomogener Struktur angehörende Verknüpfungssignale (Signale inhomogener Struktur S-IH1 bzw. S-IH2) liefern, wobei die Logikschaltungen jeder dieser Gruppen auf jedem der Halbleiterbausteine (HBI bie HBIV) in ihrer Gesemtheit vorgesehen sind, und
- durch den einzelnen Gruppen von Logikschaltungen (LSiI bis LSin) zur Bildung von Verknüpfungssignalen inhomogener Struktur nechgeschaltete Auswahlscheltglieder (AW), die über zusätzliche Eingangsklemmen der Halbleiterbausteine (HBI bis HBIV) zuführbare Steuersignale (STCO) unterschiedlich einstellbar sind, so daß die Verknüpfungssignale derselben Signalgruppe auf einander entsprechende Ausgangsklemmen (A...) verschiedener Halbleiterbausteine gleichzeitig als Ausgangssignale durchschaltbar sind.

2. Schaltungsanordnung nach Anspruch 1, dadurch gekennzeichnet, daß die von jedem Halbleiterbaustein (HB...) gleichermaßen benötigten Eingangsvariablen jeweils parallel allen Halbleiterbausteinen an miteinander korrespondierenden Eingagsklemmen (E...) zugeführt werden, während für die übrigen, abhängig von der Einstellung der Auswahlschaltglieder (AW) jeweils benötigten Eingangsvariablen auf jedem Halbleiterbaustein (HB...) eine Gruppe von miteinander korrespondierenden Eingangsklemmen (z. B. GP-I) vorgesehen ist, deren Anzahl der maximalen Anzahl der von einem der Halbleiterbausteine zusätzlich benötigten Eingangsvariabeln entspricht und die mit dem Eingängen aller entsprechenden Logikschaltungen (LSi...) für die Bildung von Ausganssignalen (S-IH) inhomogener Struktur verbunden sind.

3. Schaltungsanordnung nach Anspruch 2, dadurch gekennzeichnet, daß übereinstimmende Verknüpfungsteile (z. B. EXT) für mehrere der Logikschaltungen (LSi1 bis LSi5) zur Ableitung von Ausgangssignalen inhomogener Struktur (z. B. ALUF0 bis ALUF3 und VALUF) in einer einzigen Teil-Logikschaltung (T-LSi) zusammengefaßt sind, der die unterschiedlichen Rest-Logikschaltungen nachgeschaltet sind.

4. Schaltungsanordnung nach einem der Ansprüche 1 bis 3, dadurch gekennzeichnet, daß auf jedem Halbleiterbaustein (HB...) wenigstens für eine Reihe von Eingangsvariablen (z. B. F0-F7) Zwischenspeicher (ZSP) vorgesehen sind.

5. Schaltungsanordnung nach einem der Ansprüche 1 bis 4, dadurch gekennzeichnet, daß bei ausreichender Anzahl von Ausgängen je Halbleiterbaustein (HB...) gleichbedeutende Ausgangssignale (z. B. CIN) inhomogener Struktur von zwei der Halbleiterbausteine (z. B. HBII und HBIV) gleichzeitig abgegeben und einer Sicherungsüberwachung zugeleitet werden.

## Claims

1. A logic linking arrangement comprising a plurality of identical semiconductor modules in a highly integrated circuitry technology, characterised
- by at least one group of identical logic circuits (e.g. LSx and LSy; LSz) having a uniformly predetermined logic-linking function which form identical output signals assigned to a signal group of homogeneous structure (output signals of homogeneous structure S-H), where the logic circuits required in each group are uniformly distributed between the semiconductor modules (e.g. HBI to HBIV),
- by at least one group of logic circuits (LSi...), which each execute different logic-linking functions and each supply logic-linking signals which are thus formed in different ways and are assigned to at least one signal group of inhomogeneous structure (signals of inhomogeneous structure S-IH1; S-IH2), where the logic circuits of each of these groups are arranged in their entirety in each of the semiconductor modules (HBI to HBIV) and
- by selection switching elements (AW) which are connected to the output ends of the individual groups of logic circuits (LSil to LSin) which form logic-linking signals of inhomogeneous structure, and which can be set up in different ways via additional control signals (STCO) which can be supplied to input terminals of the semiconductor modules (HBI to HBIV) so that the logic-linking signals of the same signal group can be simultaneously switched through as output signals to mutually corresponding output terminals (A...) of different semiconductor modules.

2. A circuit arrangement as claimed in claim 1, characterised in that the input variables which are required in like manner from each semiconductor module (HB...) are each supplied in parallel to all the semiconductor modules at mutually corresponding input terminals (E...), whereas for the other input variables, which are in each case required in dependence upon the setting of the selection switching elements (AW), each semiconductor module (HB...) is provided with a group of mutually corresponding input terminals (e.g. GP-I), the number of which corresponds to the maximum number of the input variables additionally required from one of the semiconductor modules and which are connected to the inputs of all the corresponding logic circuits (LSi...) for the formation of output signals (S-IH) of inhomogeneous structure.

3. A circuit arrangement as claimed in claim 2, characterised in that identical logic-linking components (e.g. EXT) for several of the logic circuits (LSi1 to LSi5) for the acquisition of output signals of inhomogeneous structure (e.g. ALUF0 to ALUF3 and VALUF) are combined in a single subsidiary logic circuit (T-LSi) which is connected at its output to the various remaining logic circuits.

4. A circuit arrangement as claimed in one of the claims 1 to 3, characterised in that in each semiconductor module (HB...) intermediate stores (ZSP) are provided at least for a series of input variables (e.g. F0-P7).

5. A circuit arrangement as claimed in one of the claims 1 to 4, characterised in that when a sufficient number of outputs are provided in respect of each semiconductor module (HB...) equivalent output signals (e.g. CIN) of inhomogeneous structure are simultaneously emitted by two of the semiconductor modules (e.g. HBII and HBIV) and are supplied to a security monitoring unit.

## Revendications

1. Montage combinatoire logique, constitué par plusieurs modules identiques à semiconducteurs, réalisés selon la technique des circuits à haute densité d'intégration, caractérisé
- par au moins un groupe de circuits logiques similaires (par exemple LSx et LSy ou LSz) fournissant une fonction combinatoire prédéterminée de façon unitaire et servant à former des signaux de sortie similaires (signaux de sortie possédant une structure homogène S-H), associés à un groupe de signaux possédant une structure homogène, les circuits logiques nécessaires de chaque groupe étant répartis uniformément entre les modules à semiconducteurs (par exemple HBI à HBIV),
- par au moins un groupe de circuits logiques (LSi...), qui exécutent respectivement des fonctions combinatoires différentes et fournissent des signaux combinatoires (signaux possédant une structure homogène S-IH1 ou S-IH2), associés au moins à un groupe de signaux possédant une structure hétérogène, les circuits logiques de chacun de ces groupes étant prévus dans leur totalité dans chacun des modules à semiconducteurs (HBI ou HBIV), et
- par des circuits de sélection (AW), qui sont branchés en aval de différents groupes de circuits logiques (LSil à LSin) servant à la formation de signaux logiques possédant une structure hétérogène et qui peuvent être réglés différemment par l'intermédiaire de signaux supplémentaires de commande (STCO), qui peuvent être envoyés à des bornes d'entrée des modules à semiconducteurs (HBI à HBIV), de sorte que les signaux combinatoires délivrés par le même groupe de signaux peuvent être transférés simultanément en tant que signaux de sortie à des bornes de sortie (A...) qui se correspondent réciproquement, de différents modules à semiconducteurs.

2. Montage suivant la revendication 1, caractérisé par le fait que les variables d'entrée, qui sont requis de la même manière par chaque module à semiconducteurs (HB...), sont envoyés respectivement parallèlement à tous les modules à semiconducteurs, à des bornes d'entrée (E...), qui se correspondent réciproquement, tandis que pour les autres variables d'entrée, qui sont respectivement nécessaires en fonction du réglage des circuits de sélection (AW), il est prévu sur chaque module à semiconducteurs (HB...), un groupe de bornes d'entrée (par exemple GP-I), qui se correspondent entre elles et dont le nombre correspond au nombre maximum des variables d'entrée, qui sont requises en supplément par l'un des modules à semiconducteurs, et qui sont reliées aux entrées de tous les circuits logiques correspondants (LSi...) pour la formation de signaux de sortie (S-IH) possédant une structure hétérogène.

3. Montage suivant la revendication 2, caractérisé par le fait que des éléments combinatoires coïncidants (par exemple EXT) prévus pour plusieurs des circuits logiques (LSi1 à LSi5) pour la dérivée de signaux de sortie possédant une structure hétérogène (par exemple ALU0 à ALF3 et VALUF) sont réunis de manière à former un seul circuit logique partiel (T-LSi), en aval duquel sont branchés les différents autres circuits logiques.

4. Montage suivant la revendiccation 1, caractérisé par le fait que des mémoires intermédiaires (ZSP) sont prévues sur chaque module à semiconducteurs (HB...) au moins pour une série de variables d'entrée (par exemple F0-F7).

5. Montage suivant l'une des revendications 1 à 4, caractérisé par le fait que, dans le cas d'un nombre suffisant de sorties pour chaque module à semiconducteurs (HB...), des signaux de sortie équivalents (par exemple CIN) possédant une structure hétérogène sont délivrés simultanément par deux des modules à semicoducteurs (par exemple HBII et HBIV) et sont envoyés à un dispositif de contrôle de sécurité.

# FIG 1

## FIG 2

## FIG 3

| MIKROBEFEHL | | | | | | | | | ALU | | | | | CIN |
|---|---|---|---|---|---|---|---|---|---|---|---|---|---|---|
| F-FELD | | | | | | | | OPERATION | S-CODE | | | | FUNKTION | |
| F0 | F1 | F2 | F3 | F4 | F5 | F6 | F7 | | S3 | S2 | S1 | S0 | | |
| 0 | 0 | X | 0 | 0 | 0 | 0 | 0 | ADD DEC | 0 | 0 | 0 | 0 | }A PLUS B DEC | 0 |
| | | | 0 | 0 | 0 | 0 | 1 | ADD DEC +C | 0 | 0 | 0 | 0 | | CARRY |
| | | | 0 | 0 | 0 | 1 | 0 | SUB DEC | 0 | 0 | 0 | 1 | | 1 |
| | | | 0 | 0 | 0 | 1 | 1 | SUB DEC +C | 0 | 0 | 0 | 1 | }A MINUS B DEC | CARRY |
| | | | 0 | 0 | 1 | 0 | 0 | COMP DEC | 0 | 0 | 0 | 1 | | 1 |
| | | | 0 | 0 | 1 | 0 | 1 | COMP DEC +C | 0 | 0 | 0 | 1 | | CARRY |
| | | | 0 | 0 | 1 | 1 | 0 | COMPL DEC | 0 | 0 | 1 | 1 | }COMPL B DEC | 1 |
| | | | 0 | 0 | 1 | 1 | 1 | COMPL DEC +C | 0 | 0 | 1 | 1 | | CARRY |
| 0 | 0 | X | 0 | 1 | 0 | 0 | 0 | ADD BIN | 0 | 1 | 0 | 0 | }A PLUS B BIN | 0 |
| | | | 0 | 1 | 0 | 0 | 1 | ADD BIN +C | 0 | 1 | 0 | 0 | | CARRY |
| | | | 0 | 1 | 0 | 1 | 0 | SUB BIN | 0 | 1 | 0 | 1 | | 1 |
| | | | 0 | 1 | 0 | 1 | 1 | SUB BIN +C | 0 | 1 | 0 | 1 | }A MINUS B BIN | CARRY |
| | | | 0 | 1 | 1 | 0 | 0 | COMP BIN | 0 | 1 | 0 | 1 | | 1 |
| | | | 0 | 1 | 1 | 0 | 1 | COMP BIN +C | 0 | 1 | 0 | 1 | | CARRY |
| | | | 0 | 1 | 1 | 1 | 0 | COMPL BIN | 0 | 1 | 1 | 1 | }COMPL B BIN | 1 |
| | | | 0 | 1 | 1 | 1 | 1 | COMPL BIN +C | 0 | 1 | 1 | 1 | | CARRY |
| 0 | 0 | X | 1 | 0 | 0 | 0 | 0 | EXNOR | 1 | 0 | 0 | 0 | }A ≡ B | X |
| | | | 1 | 0 | 0 | 0 | 1 | EXNOR | 1 | 0 | 0 | 0 | | |
| | | | 1 | 0 | 0 | 1 | 0 | EXOR | 1 | 0 | 0 | 1 | }A ≠ B | |
| | | | 1 | 0 | 0 | 1 | 1 | EXOR | 1 | 0 | 0 | 1 | | |
| | | | 1 | 0 | 1 | 0 | 0 | OR | 1 | 0 | 1 | 0 | }A + B | |
| | | | 1 | 0 | 1 | 0 | 1 | OR | 1 | 0 | 1 | 0 | | |
| | | | 1 | 0 | 1 | 1 | 0 | AND | 1 | 1 | 1 | 0 | }A·B | |
| | | | 1 | 0 | 1 | 1 | 1 | AND | 1 | 1 | 1 | 0 | | |
| 0 | 0 | X | 1 | 1 | 0 | 0 | 0 | NOT (B) | 1 | 1 | 0 | 0 | B̄ | |
| | | | 1 | 1 | 0 | 0 | 1 | TRINSTR | X | X | X | X | | |
| | | | 1 | 1 | 0 | 1 | 0 | TRANSF(B) | | | | | ALU WIRD NICHT | |
| | | | 1 | 1 | 0 | 1 | 1 | TR.W.SIGN (B) | | | | | }BENÖTIGT | |
| | | | 1 | 1 | 1 | 0 | 0 | TREXA | | | | | | |
| | | | 1 | 1 | 1 | 0 | 1 | TREXB | | | | | | |
| | | | 1 | 1 | 1 | 1 | 0 | INSERT | X | X | X | X | | |
| | | | 1 | 1 | 1 | 1 | 1 | EXTRACT | 1 | 0 | 1 | 1 | A | X |
| 0 | 1 | 0 | X | X | X | X | X | SHIFT | X | X | X | X | X | X |
| 0 | 1 | 1 | 0 | X | X | X | X | INSERT | X | X | X | X | X | X |
| | | 1 | 1 | | | | | EXTRACT | 1 | 0 | 1 | 1 | A | |
| 1 | 0 | X | X | X | X | X | X | ADD BIN | 0 | 1 | 0 | 0 | A PLUS B BIN | 0 |
| | | X | X | X | X | X | X | SUB BIN | 0 | 1 | 0 | 1 | A MINUS B BIN | 1 |

## FIG 4

| PAM Bit: | 0 | 1 | 2 | 3 | 4 | 5 | 6 | 7 |
|---|---|---|---|---|---|---|---|---|
| B-GR0 | 0 | 0 | W | A LU-F | | | | |
| B-GR1 | 0 | 1 | SH-F | | | | | |
| B-GR2 | 1 | 0 | V | AU-F | | | | |
| F-Bit: | F0 | F1 | F2 | F3 | F4 | F5 | F6 | F7 |

## FIG 5

| B-GR. | Oper. | PAM.25 | ALUF3 | ALUF2 | ALUF1 | ALUF0 |
|---|---|---|---|---|---|---|
| 0 | ¬EXT | X | S3 | S2 | S1 | S0 |
| 1 | ¬EXT | X | X | X | X | X |
| X | EXT | X | 1 | 0 | 1 | 1 |
| 2 | X | 0 (+) | 0 | 1 | 0 | 0 |
|   |   | 1 (−) | 0 | 1 | 0 | 1 |

## FIG 6

| IVALUF | VALUF0 |
|---|---|
| 0 | ALUF0 |
| 1 | $\overline{\text{ALUF0}}$ |

**FIG 7**

$$ALUF3 = EXT + \overline{GR2} \cdot S3$$
$$ALUF2 = GR2 + \overline{EXT} \cdot S2$$
$$ALUF1 = EXT + \overline{GR2} \cdot S1$$
$$ALUF0 = EXT + \overline{GR2} \cdot S0 + GR2 \cdot PAM\,25$$

$$VALUF0 = \overline{IVALUF} \cdot ALUF0 + IVALUF \cdot \overline{ALUF0}$$
$$= IVALUF \neq ALUF0$$

mit:
$$S3 = F3$$
$$S2 = F4 + F3 \cdot F5 \cdot F6$$
$$S1 = F5 \cdot (F3 + F6)$$
$$S0 = \overline{F3} \cdot F5 + \overline{F5} \cdot F6$$

$$GR2 = F0$$
$$EXT = \overline{F0} \cdot \overline{F1} \cdot F3 \cdot F4 \cdot F5 \cdot F6 \cdot F7 + \overline{F0} \cdot F1 \cdot F2 \cdot F3$$

## FIG 8

| B-GR | Operations-art | Bit F7 | Operation | CIN |
|---|---|---|---|---|
| 0 ⎬ ¬2 | Arithmetisch (Binär/Dezimal) | 0 | Addition ¬Addition | 0 1 |
| | | 1 | X | CARRY |
| | Logisch Transfer | X | X | X |
| 1 | X | X | X | X |
| 2 | X | X | X | PAM 25 |

$$CIN = \overline{GR2} \cdot (\overline{F7} \cdot \overline{ADD} + F7 \cdot CARRY) + GR2 \cdot PAM\,25$$
mit: $ADD = \overline{F3} \cdot \overline{F5} \cdot \overline{F6}$
$$GR2 = F0$$

**FIG 9**

| HB: | I | II | III | IV |
|---|---|---|---|---|
| STCO1: | 0 | 1 | 0 | 1 |
| Ax | ALUF1 | VALUF0 | ALUF1 | VALUF0 |
| Ay | ALUF2 | ALUF0 | ALUF2 | ALUF0 |
| Az | ALUF3 | CIN | ALUF3 | CIN |

**FIG 10**

$$NZDx = ADM0 \cdot (NZD-I0 + NZD-I1 + NZD-I2 + NZD-I3)$$

$$+ ADM1 \cdot (NZD-I4 + NZD-I5 + NZD-I6 + NZD-I7)$$

| | NZDx | ADM0 | NZD-I0→3 | ADM1 | NZD-I4→7 |
|---|---|---|---|---|---|
| HB I: | NZD 01 | ADIG 0 | CBUS 00→03 | ADIG 1 | CBUS 04→07 |
| HB II: | NZD 23 | ADIG 2 | CBUS 08→11 | ADIG 3 | CBUS 12→15 |
| HB III: | NZD 45 | ADIG 4 | CBUS 16→19 | ADIG 5 | CBUS 20→23 |
| HB IV: | NZD 67 | ADIG 6 | CBUS 24→27 | ADIG 7 | CBUS 28→31 |

**FIG 11**

$$S-BYTSEL\ H = MD \cdot (ADM0 + ADM1) \cdot \overline{AC-BIT6} \cdot TWREG$$
$$S\ BYTSEL\ L = MD \cdot (ADM0 + ADM1) \cdot AC-BIT6 \cdot TWREG$$

| | S-BYTSEL H | S-BYTSEL L | ADM0 | ADM1 |
|---|---|---|---|---|
| HB I: | S-BYT 0 | S-BYT 4 | ADIG 0 | ADIG 1 |
| HB II: | S-BYT 1 | S-BYT 5 | ADIG 2 | ADIG 3 |
| HB III: | S-BYT 2 | S-BYT 6 | ADIG 4 | ADIG 5 |
| HB IV: | S-BYT 3 | S-BYT 7 | ADIG 6 | ADIG 7 |

## FIG 12

| MIKROBEFEHL | | | | | | | | | ALU | | | | | |
|---|---|---|---|---|---|---|---|---|---|---|---|---|---|---|
| | | F-FELD | | | | | | OPERATION | | | | | | |
| F0 | F1 | F2 | F3 | F4 | F5 | F6 | F7 | | CARRY | OV | SIGN | PCAR | NZD | IVD |
| 0 | 0 | X | 0 | 0 | 0 | 0 | 0 | ADD DEC | SR | | | | SR | SR |
| | | | 0 | 0 | 0 | 0 | 1 | ADD DEC +C | | | | | S | S |
| | | | 0 | 0 | 0 | 1 | 0 | SUB DEC | | | | | SR | SR |
| | | | 0 | 0 | 0 | 1 | 1 | SUB DEC +C | | | | | S | S |
| | | | 0 | 0 | 1 | 0 | 0 | COMP DEC | | | | | SR | SR |
| | | | 0 | 0 | 1 | 0 | 1 | COMP DEC +C | | | | | S | S |
| | | | 0 | 0 | 1 | 1 | 0 | COMPL DEC | | | | | SR | SR |
| | | | 0 | 0 | 1 | 1 | 1 | COMPL DEC +C | | | | | S | S |
| 0 | 0 | X | 0 | 1 | 0 | 0 | 0 | ADD BIN | | SR | SR | SR | SR | |
| | | | 0 | 1 | 0 | 0 | 1 | ADD BIN +C | | | | | S | |
| | | | 0 | 1 | 0 | 1 | 0 | SUB BIN | | | | | SR | |
| | | | 0 | 1 | 0 | 1 | 1 | SUB BIN +C | | | | | S | |
| | | | 0 | 1 | 1 | 0 | 0 | COMP BIN | | | | | SR | |
| | | | 0 | 1 | 1 | 0 | 1 | COMP BIN +C | | | | | S | |
| | | | 0 | 1 | 1 | 1 | 0 | COMPL BIN | | | | | SR | |
| | | | 0 | 1 | 1 | 1 | 1 | COMPL BIN +C | SR | SR | SR | SR | S | |
| 0 | 0 | X | 1 | 0 | 0 | 0 | 0 | EXNOR | | | | | SR | |
| | | | 1 | 0 | 0 | 0 | 1 | EXNOR | | | | | S | |
| | | | 1 | 0 | 0 | 1 | 0 | EXOR | | | | | SR | |
| | | | 1 | 0 | 0 | 1 | 1 | EXOR | | | | | S | |
| | | | 1 | 0 | 1 | 0 | 0 | OR | | | | | SR | |
| | | | 1 | 0 | 1 | 0 | 1 | OR | | | | | S | |
| | | | 1 | 0 | 1 | 1 | 0 | AND | | | | | SR | |
| | | | 1 | 0 | 1 | 1 | 1 | AND | | | | | S | |
| 0 | 0 | X | 1 | 1 | 0 | 0 | 0 | NOT(B) | | | | | | |
| | | | 1 | 1 | 0 | 0 | 1 | TRINSTR | | | | | | |
| | | | 1 | 1 | 0 | 1 | 0 | TRANSF(B) | | | | | | |
| | | | 1 | 1 | 0 | 1 | 1 | TR.W.SIGN(B) | | | | | | |
| | | | 1 | 1 | 1 | 0 | 0 | TREXA | | | | | | |
| | | | 1 | 1 | 1 | 0 | 1 | TREXB | | | | | | |
| | | | 1 | 1 | 1 | 1 | 0 | INSERT | | | | | | |
| | | | 1 | 1 | 1 | 1 | 1 | EXTRACT | | | | | | |
| 0 | 1 | 0 | X | X | X | X | X | SHIFT | | | | | | |
| 0 | 1 | 1 | 0 | X | X | X | X | INSERT | | | | | | |
| | | 1 | 1 | | | | | EXTRACT | | | | | | |
| 1 | 0 | X | X | X | X | X | X | ADD BIN | | | | SR | | |
| | | X | X | X | X | X | X | SUB BIN | | | | SR | | |

# FIG 13

# FIG 14

CARRY:

| B-GR. | OP | SET | RES |
|---|---|---|---|
| ¬0 | X | 0 | 0 |
| 0 | ARITHM. | CO | $\overline{CO}$ |
|  | ¬ARITHM. | 0 | 0 |

$$S\text{-}CARRY = GR0 \cdot ARITHM \cdot \overline{CO}$$
$$R\text{-}CARRY = GR0 \cdot ARITHM \cdot \overline{CO}$$
$$\text{mit}: \quad GR0 = \overline{F0} \cdot \overline{F1}$$
$$ARITHM = \overline{F3}$$

## FIG 15

SIGN/OV:

| B-GR. | OP | SET | RES |
|-------|-----|------|------|
| ¬0 | X | 0 | 0 |
| 0 | BIN | SIGN OV | $\overline{\text{SIGN}}$ $\overline{\text{OV}}$ |
|   | ¬BIN | 0 | 0 |

$S\text{-}SIGN = GRO \cdot BIN \cdot SIGN$

$R\text{-}SIGN = GRO \cdot BIN \cdot \overline{SIGN}$

$S\text{-}OV = GRO \cdot BIN \cdot OV$

$R\text{-}OV = GRO \cdot BIN \cdot \overline{OV}$

mit:

$GRO = \overline{F0} \cdot F1$

$BIN = \overline{F3} \cdot F4$

$OV = [(ABIT OV \neq BBIT OV) \neq ALU 00] \neq C0$

## FIG 16

PCAR:

| B-GR. | OP | SET | RES |
|-------|-----|------|------|
| 1 | X | 0 | 0 |
| 0 | BIN | PCAR | $\overline{\text{PCAR}}$ |
|   | ¬BIN | 0 | 0 |
| 2 | X | PCAR | $\overline{\text{PCAR}}$ |

$S\text{-}PCAR = (GRO \cdot BIN + GR2) \cdot PCAR$

$R\text{-}PCAR = (GRO \cdot BIN + GR2) \cdot \overline{PCAR}$

mit:

$GRO = \overline{F0} \cdot F1$

$BIN = \overline{F3} \cdot F4$

$GR2 = F0$

$PCAR = \overline{PSIZE} \cdot (ABIT19 \neq ALU19) + PSIZE \cdot (ABIT20 \neq ALU20)$

## FIG 17

NZD:

| B-GR. | OP | F7 | SET | RES |
|-------|--------|----|-----|-----|
| ¬0 | X | X | 0 | 0 |
| 0 | TRANSF | X | 0 | 0 |
|   | ¬TRANSF | 0 | NZD | $\overline{\text{NZD}}$ |
|   |   | 1 | NZD | 0 |

$S\text{-}NZD = GRO \cdot \overline{TRANSF} \cdot NZD$

$R\text{-}NZD = GRO \cdot \overline{TRANSF} \cdot F7 \cdot \overline{NZD}$

mit:

$GRO = \overline{F0} \cdot F1$

$TRANSF = F3 \cdot F4$

$NZD = NZD01 + NZD23 + NZD45 + NZD67$

17

## FIG 18

IVD:

| B-GR. | OP | F7 | SET | RES |
|---|---|---|---|---|
| 0 | X | X | 0 | 0 |
| 0 | ¬DEZ | X | 0 | 0 |
| | DEZ | 0 | IVD | $\overline{IVD}$ |
| | | 1 | IVD | 0 |

$$S\text{-}IVD = GRO \cdot DEZ \cdot IVD$$
$$R\text{-}IVD = GRO \cdot DEZ \cdot F7 \cdot \overline{IVD}$$

mit: $GRO = \overline{F0} \cdot \overline{F1}$
$DEZ = \overline{F3} \cdot \overline{F4}$
$IVD = IVDH + IVDL$

## FIG 19

| | | Signale an HB | | | |
|---|---|---|---|---|---|
| | | I | II | III | IV |
| E... | GPI0 | ABIT OV | CARRY[+] | A BIT 19 | CARRY[+] |
| | GPI1 | BBIT OV | IVALUF[+] | ALU. 19 | IVALUF[+] |
| | GPI2 | ALU. 00 | SIGN | ABIT 20 | NZD 01 |
| | GPI3 | C0 | IVDH | ALU. 20 | NZD 23 |
| | GPI4 | * | IVDL | PSIZE | NZD 45 |
| A... | GPD0 | S-CARRY | S-SIGN | S-PCAR | S-NZD |
| | GPD1 | R-CARRY | R-SIGN | R-PCAR | R-NZD |
| | GPD2 | S-OV | S-IVD | ADD[++] | * |
| | GPD3 | R-OV | R-IVD | GR2[++] | DEZ OP[++] |
| | GPD4 | * | INSERT[++] | * | COMP[++] |
| | GPD5 | * | EXTRACT[++] | * | TRINST[++] |

(*): Klemme wird anderweitig belegt

(+): Signale nicht für Steuerung der ALU-ANZEIGE

(++): Zusätzliche Steuersignale

**FIG 20**

E-HB:  I  II  III  IV       A-H:  I  II  III  IV

| | I | II | III | IV | | | I | II | III | IV |
|---|---|---|---|---|---|---|---|---|---|---|
| | N | N | P | P | 0 STCO | | | | | |
| | N | P | N | P | 1 | | | | | |
| T1 | | | | | CLS | | | | | |
| T3 | | | | | CLR | | | | | |
| PAM00 | | | | | 0 F | VALUF0/ALUF1 | ALUF1 | VALUF0 | ALUF1 | VALUF0 |
| | | | | | | ALUF 0/2 | ALUF2 | ALUF 0 | ALUF2 | ALUF0 |
| PAM07 | | | | | 7 | CIN/ALUF 3 | ALUF 3 | CIN | ALUF 3 | CIN |
| PAM25 | | | | | PAM25 | | | | | |
| ADIG 0 | ~2 | ~4 | ~6 | | 0 ADM | | | | | |
| ADIG 1 | ~3 | ~5 | ~7 | | 1 | | | | | |
| MD | | | | | MD | | | | | |
| AC-BIT6 | | | | | AC-BIT6 | S-BYTSEL H | SBYT 0 | ~1 | ~2 | ~3 |
| T12 | | | | | TWREG | S-BYTSEL L | SBYT 4 | ~5 | ~6 | ~7 |
| C-BUS 00 | ~08 | ~16 | ~24 | | 0 NZD-I | | | | | |
| | | | | | | NZDx | NZD 01 | ~23 | ~45 | ~67 |
| C-BUS 07 | ~15 | ~23 | ~31 | | 7 | | | | | |
| A BIT OV | CARRY | A BIT 19 | CARRY | | 0 GP-I | | S-CARRY | S-IVD | S-PCAR | S-NZD |
| B BIT OV | IVALUF | ALU 19 | IVALUF | | 1 | GP-O | R-CARRY | R-IVD | R-PCAR | R-NZD |
| ALU 00 | SIGN | A BIT 20 | NZD 01 | | | | S-OV | S-SIGN | ADD | * |
| C0 | IVD H | ALU 20 | NZD 23 | | | | R-OV | R-SIGN | GR2 | DECOP |
| * | IVD L | PSIZE | NZD 45 | | 4 | 5 | * | INSERT | * | COMP |
| | | | | | | | * | EXTRACT | * | TRINST |